# EUROPEAN PATENT APPLICATION

(11) **EP 3 493 243 A1**
(43) Date of publication of application: **05.06.2019**
(21) Application number: 18206906.2
(22) Date of filing: 19.11.2018
(51) Int. Cl.: H01L 21/28, H01L 29/423, H01L 29/66, H01L 29/78, H01L 29/792, H01L 27/1157

(54) **A SEMICONDUCTOR DEVICE AND A MANUFACTURING METHOD THEREOF**

(30) Priority: 30.11.2017 JP 2017229777
(71) Applicant: Renesas Electronics Corporation, 135-0061 Tokyo (JP)
(72) Inventor: TSUDA, Shibun, Tokyo, 135-0061 (JP)
(74) Representative: Betten & Resch

(57) **Abstract**

The performances of a semiconductor device are improved. A plurality of first gate patterns are formed over a fin of a part of a semiconductor substrate. A gate insulation film including a metal oxide film is formed between the adjacent first gate patterns. Then, a memory gate electrode is formed over the gate insulation film to fill between the adjacent first gate patterns. Then, the first gate patterns are selectively removed, to form a second gate pattern at the side surface of the memory gate electrode via the gate insulation film. Then, ions are implanted into the fin exposed from the memory gate electrode and the second gate pattern, to form an extension region in the fin. During formation of the extension region, the gate insulation film is not formed at the side surface of the fin, and hence ion implantation is not inhibited.

## Description

### CROSS-REFERENCE TO RELATED APPLICATIONS

The disclosure of Japanese Patent Application No.2017-229777 filed on November 30, 2017 including the specification, drawings and abstract is incorporated herein by reference in its entirety.

### BACKGROUND

The present invention relates to a semiconductor device and a manufacturing method thereof. More particularly, it relates to a technology effectively applicable to a semiconductor device including a fin type transistor.

As a field effect transistor capable of achieving a higher operating speed, reduction of leakage current and power consumption, and miniaturization of a semiconductor element, a fin type transistor is known. The fin type transistor (FINFET: FIN Field Effect Transistor) is, for example, a semiconductor element having a semiconductor layer projecting over a semiconductor substrate as a channel region, and having a gate electrode formed in such a manner as to extend across over the projecting semiconductor layer.

Further, as electrically writable / erasable nonvolatile semiconductor memories, flash memories or EEPROMs (Electrically Erasable and Programmable Read Only Memories) have been widely used. The storage devices have conductive floating gate electrodes surrounded by an oxide film, or trapping insulation films under gate electrodes of MISFETs (Metal Insulator Semiconductor Field Effect Transistors). The storage devices use charge accumulation states at the floating gate electrodes or the trapping insulation films as stored information, and read out the information as a threshold value of each transistor. The trapping insulation film denotes an insulation film capable of accumulating electric charges. As one example thereof, mention may be made of a silicon nitride film. Implantation / discharge of electric charges into such charge accumulation layers causes each MISFET to be shifted in threshold value and to operate as a storage element. The flash memory is also referred to as a MONOS (Metal-Oxide-Nitride-Oxide-Semiconductor) type transistor. Further, a split gate type memory cell using a MONOS type transistor as a transistor for memory, and further additionally having a transistor for control has been widely used.

Patent Document 1 discloses a technology of forming a split gate type memory cell including a MONOS type transistor with a FINFET structure.

Patent Document 2 discloses the following technology: a split gate type memory cell is formed by burying the gate electrode of a MONOS type transistor between the gate electrode of a transistor for control and a dummy pattern.

### Cited Documents

[Patent Document 1] Japanese Unexamined Patent Application Publication No. 2017-045860
[Patent Document 2] Japanese Unexamined Patent Application Publication No. 2016-165010

### SUMMARY

When a split gate type memory cell including a MONOS type transistor is formed with a fin structure, in order to improve the performances of the memory cell, a technology of enhancing the controllability of ion implantation into the fin, a technology of forming an epitaxial layer at the fin surface with stability, or other technologies have been desired.

Other objects and novel features will be apparent from the description of this specification and the accompanying drawings.

Representative ones of the embodiments disclosed in the present application will be briefly described as follows.

A method for manufacturing a semiconductor device of one embodiment includes the steps of: forming a plurality of first gate patterns over a projecting part of a part of a semiconductor substrate; forming a first gate insulation film including a metal oxide film between the adjacent first gate patterns; and forming a memory gate electrode over the first gate insulation film in such a manner as to fill between the adjacent first gate patterns. Further, the method for manufacturing a semiconductor device includes the steps of: selectively removing the plurality of first gate patterns, and thereby forming a second gate pattern at the side surface of the memory gate electrode via the first gate insulation film; and ion implanting the projecting part exposed from the memory gate electrode and the second gate pattern, and thereby forming an impurity region in the projecting part.

In accordance with one embodiment, it is possible to improve the performances of a semiconductor device.

### BRIEF DESCRIPTION OF THE DRAWINGS

FIG. 1 is a schematic view showing a layout configuration of a semiconductor chip of First Embodiment;
FIG. 2 is a plan view showing a semiconductor device of First Embodiment;
FIG. 3 is a perspective view showing the semiconductor device of First Embodiment;
FIG. 4 is a cross sectional view showing the semiconductor device of First Embodiment;
FIG. 5 is an equivalent circuit diagram of a memory cell;
FIG. 6 is a table showing one example of the application conditions of a voltage to each site of a selection memory cell at the times of "write", "erase", and "read";
FIG. 7 is a perspective view for illustrating the semiconductor device of First Embodiment during a manufacturing step;
FIG. 8 is a perspective view for illustrating the semiconductor device during a manufacturing step following FIG. 7;
FIG. 9 is a perspective view for illustrating the semiconductor device during a manufacturing step following FIG. 8;
FIG. 10 is a perspective view for illustrating the semiconductor device during a manufacturing step following FIG. 9;
FIG. 11 is a perspective view for illustrating the semiconductor device during a manufacturing step following FIG. 10;
FIG. 12 is a perspective view for illustrating the semiconductor device during a manufacturing step following FIG. 11;
FIG. 13 is a cross sectional view for illustrating the semiconductor device during a manufacturing step following FIG. 12;
FIG. 14 is a cross sectional view for illustrating the semiconductor device during a manufacturing step following FIG. 13;
FIG. 15 is a cross sectional view for illustrating the semiconductor device during a manufacturing step following FIG. 14;
FIG. 16 is a cross sectional view for illustrating the semiconductor device during a manufacturing step following FIG. 15;
FIG. 17 is a cross sectional view for illustrating the semiconductor device during a manufacturing step following FIG. 16;
FIG. 18 is a cross sectional view for illustrating the semiconductor device during a manufacturing step following FIG. 17;
FIG. 19 is a cross sectional view for illustrating the semiconductor device during a manufacturing step following FIG. 18;
FIG. 20 is a cross sectional view for illustrating the semiconductor device during a manufacturing step following FIG. 19;
FIG. 21 is a cross sectional view for illustrating the semiconductor device during a manufacturing step following FIG. 20;
FIG. 22 is a cross sectional view for illustrating the semiconductor device during a manufacturing step following FIG. 21;
FIG. 23 is a cross sectional view for illustrating the semiconductor device during a manufacturing step following FIG. 22;
FIG. 24 is a cross sectional view for illustrating the semiconductor device during a manufacturing step following FIG. 23;
FIG. 25 is a cross sectional view for illustrating the semiconductor device during a manufacturing step following FIG. 24;
FIG. 26 is a cross sectional view for illustrating the semiconductor device during a manufacturing step following FIG. 25;
FIG. 27 is a cross sectional view for illustrating the semiconductor device during a manufacturing step following FIG. 26;
FIG. 28 is a cross sectional view showing a semiconductor device of Modified Example 1 of First Embodiment;
FIG. 29 is a cross sectional view showing a semiconductor device of Modified Example 2 of First Embodiment;
FIG. 30 is a plan view showing a power feeding part of the semiconductor device of First Embodiment;
FIG. 31 is a cross sectional view showing the power feeding part of the semiconductor device of First Embodiment;
FIG. 32 is a plan view for illustrating the semiconductor device during a manufacturing step following FIG. 30;
FIG. 33 is a cross sectional view for illustrating the semiconductor device during a manufacturing step following FIG. 31;
FIG. 34 is a plan view for illustrating the semiconductor device during a manufacturing step following FIG. 32;
FIG. 35 is a cross sectional view for illustrating the semiconductor device during a manufacturing step following FIG. 33;
FIG. 36 is a plan view for illustrating the semiconductor device during a manufacturing step following FIG. 34;
FIG. 37 is a cross sectional view for illustrating the semiconductor device during a manufacturing step following FIG. 35;
FIG. 38 is a plan view for illustrating the semiconductor device during a manufacturing step following FIG. 36;
FIG. 39 is a cross sectional view for illustrating the semiconductor device during a manufacturing step following FIG. 37;
FIG. 40 is a plan view for illustrating the semiconductor device during a manufacturing step following FIG. 38;
FIG. 41 is a cross sectional view for illustrating the semiconductor device during a manufacturing step following FIG. 39;
FIG. 42 is a plan view for illustrating the semiconductor device during a manufacturing step following FIG. 40;
FIG. 43 is a cross sectional view for illustrating the semiconductor device during a manufacturing step following FIG. 41;
FIG. 44 is a plan view for illustrating the semiconductor device during a manufacturing step following FIG. 42;
FIG. 45 is a cross sectional view for illustrating the semiconductor device during a manufacturing step following FIG. 43;
FIG. 46 is a plan view for illustrating the semiconductor device during a manufacturing step following FIG. 44;
FIG. 47 is a cross sectional view for illustrating the semiconductor device during a manufacturing step following FIG. 45;
FIG. 48 is a plan view for illustrating the semiconductor device during a manufacturing step following FIG. 46;
FIG. 49 is a cross sectional view for illustrating the semiconductor device during a manufacturing step following FIG. 47;
FIG. 50 is a cross sectional view showing a semiconductor device of Second Embodiment;
FIG. 51 is a cross sectional view showing a semiconductor device of Study Example;
FIG. 52 is a cross sectional view for illustrating the semiconductor device during a manufacturing step following FIG. 51;
FIG. 53 is a cross sectional view for illustrating the semiconductor device during a manufacturing step following FIG. 52;
FIG. 54 is a cross sectional view for illustrating the semiconductor device during a manufacturing step following FIG. 53;
FIG. 55 is a cross sectional view showing the problem of the semiconductor device of Study Example;
FIG. 56 is a cross sectional view showing the problem of the semiconductor device of Study Example;
FIG. 57 is a plan view showing a power feeding part of the semiconductor device of Study Example;
FIG. 58 is a plan view for illustrating the semiconductor device during a manufacturing step following FIG. 57;
FIG. 59 is a plan view for illustrating the semiconductor device during a manufacturing step following FIG. 58;
FIG. 60 is a plan view for illustrating the semiconductor device during a manufacturing step following FIG. 59; and
FIG. 61 is a cross sectional view showing the power feeding part of the semiconductor device of Study Example.

### DETAILED DESCRIPTION

In description of the following embodiment, the embodiment may be described in a plurality of divided sections or embodiments for convenience, if required. However, unless otherwise specified, these are not independent of each other, but are in a relation such that one is a modified example, details, a complementary explanation, or the like of a part or the whole of the other. Further, in the following embodiments, when a reference is made to the number of elements, and the like (including number, numerical value, quantity, range, or the like), the number of elements, or the like is not limited to the specific number, but may be greater than or less than the specific number, unless otherwise specified, except for the case where the number is apparently limited to the specific number in principle, or except for other cases. Further, in the following embodiments, it is needless to say that the constitutional elements (including element steps, or the like) are not always essential, unless otherwise specified, and except for the case where they are apparently considered essential in principle, or except for other cases. Similarly, in the following embodiments, when a reference is made to the shapes, positional relationships, or the like of the constitutional elements, or the like, it is understood that they include ones substantially analogous or similar to the shapes or the like, unless otherwise specified, and unless otherwise considered apparently in principle, or except for other cases. This also applies to the foregoing numerical values and ranges.

Below, the embodiments will be described in details by reference to the accompanying drawings. Incidentally, in all the drawings for describing the embodiments, the members having the same function are given the same reference signs and numerals, and a repeated description thereon is omitted. Further, in the following embodiments, a description on the same or similar part will not be repeated in principle unless otherwise required.

Further, in drawings for use in the embodiments, hatching may be omitted for ease of understanding of the drawing.

### First Embodiment

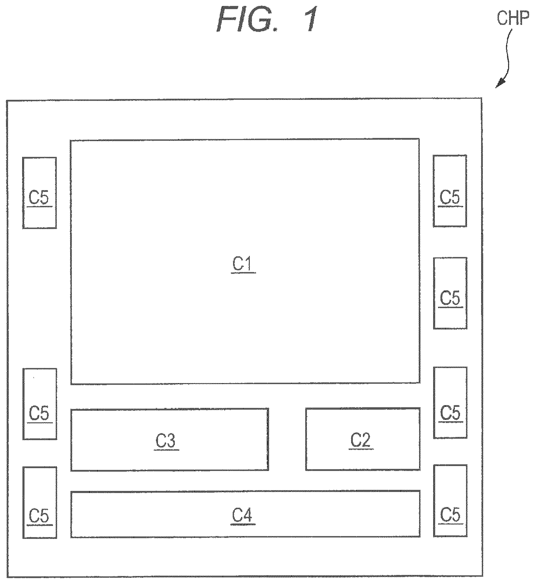

A semiconductor device having a nonvolatile memory in the present embodiment will be described by reference to the accompanying drawings. First, a description will be given to the layout configuration of a semiconductor device (semiconductor chip) in which a system including a nonvolatile memory is formed. FIG. 1 is a schematic view showing the layout configuration example of a semiconductor chip CHP in the present embodiment. In FIG. 1, the semiconductor chip CHP has a nonvolatile memory circuit C1, a CPU (Central Processing Unit) circuit C2, a RAM (Random Access Memory) circuit C3, an analog circuit C4, and an I/O (Input/Output) circuit C5.

The nonvolatile memory circuit C1 has an EEPROM, a flash memory, and the like capable of electrically writing storage information, and is, for example, a region where a MONOS type transistor is formed as a semiconductor element.

The CPU circuit C2 has a logic circuit driven at a voltage of about 1.5V, and is a region where a low breakdown voltage MISFET having a low breakdown voltage, and operating at a high speed is formed as a semiconductor element.

The RAM circuit C3 has a SRAM (Static RAM), and is a region where a low breakdown voltage MISFET of almost the same structure as that of the CPU circuit C2 is formed as a semiconductor element.

The analog circuit C4 has an analog circuit, and is a region where a high breakdown voltage MISFET having a higher breakdown voltage than that of a low breakdown voltage MISFET, and driven at a voltage of about 6 V, a capacitive element, a resistance element, a bipolar transistor, and the like are formed as semiconductor elements.

The I/O circuit C5 has an input / output circuit, and is a region where almost the same high breakdown voltage MISFET as that of the analog circuit C4 is formed as a semiconductor element.

### <Device structure of semiconductor device>

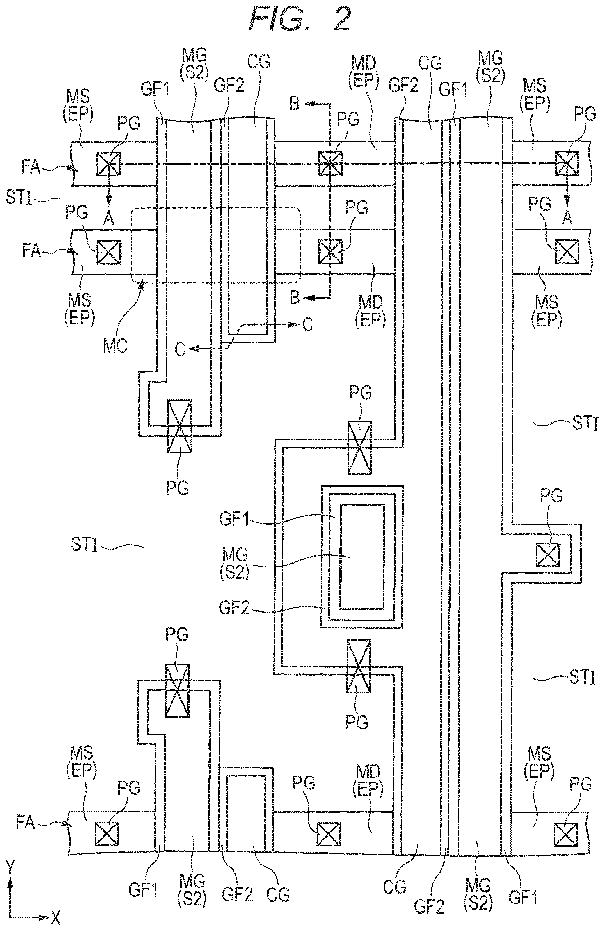

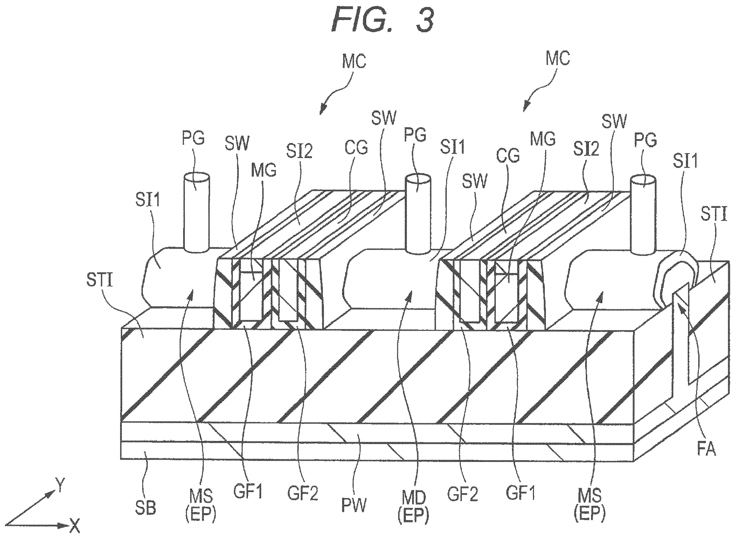

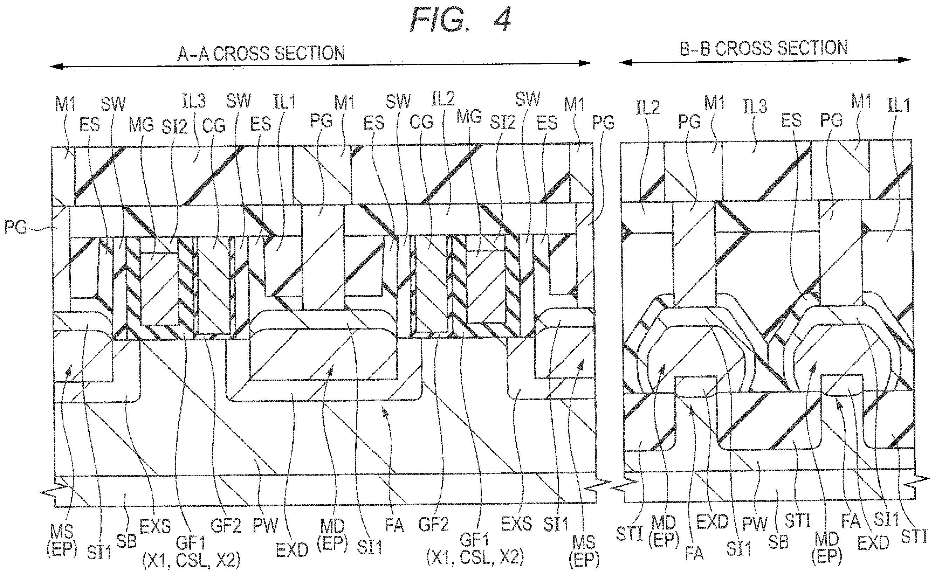

Below, referring to FIGS. 2 to 4, the structure of the semiconductor device of the present embodiment will be described. FIG. 2 is a plan view of a part of the nonvolatile memory circuit C1 of FIG. 1. FIG. 3 is a perspective view of two memory cells MC of a part of the nonvolatile memory circuit C1. FIG. 4 shows a cross sectional view corresponding to line A-A and line B-B of FIG. 2.

As shown in FIGS. 2 to 4, in the nonvolatile memory circuit C1, a plurality of fins FA extending in the X direction are arranged at regular intervals in the Y direction. The X direction and the Y direction are directions along the main surface of the semiconductor substrate SB. The X direction is orthogonal to the Y direction. That is, the X direction is the direction of long sides of the fin FA, and the Y direction is the direction of short sides of the fin FA. The fin FA is a part of the semiconductor substrate SB, and a projecting part (convex part) in a rectangular parallelepiped selectively projecting from the main surface of the semiconductor substrate SB.

Over the semiconductor substrate SB between the plurality of fins FA, an element isolation part STI is formed. The position of the upper surface of the element isolation part STI is lower than the position of the upper surface of the fin FA. In other words, a part of the fin FA projects from the element isolation part STI. In the present embodiment, the part of the fin FA at a higher position than that of the upper surface of the element isolation part STI may be referred to as the upper part of the fin FA, and the part of the fin FA at a lower position than that of the upper surface of the element isolation part STI may be referred to as the lower part of the fin FA. That is, respective upper parts of fins FA are insulated and isolated by the element isolation part STI.

The upper part of the fin FA is mainly an active region for forming the memory cell MC. That is, the region of the semiconductor substrate SB defined by the element isolation part STI is an active region.

Incidentally, the fin FA is not necessarily required to be a rectangular parallelepiped, and may be rounded at the corner parts of the rectangle in a cross sectional view in the short side direction. Further, the side surface of the fin FA may be perpendicular to the main surface of the semiconductor substrate SB, and may have a tilt angle close to the perpendicular angle. In other words, the cross sectional shape of the fin FA is a rectangular parallelepiped, or a trapezoid.

Over the plurality of fins FA, a plurality of memory gate electrodes MG and a plurality of control gate electrodes CG extending in the Y direction are arranged. The plurality of memory gate electrodes MG and the plurality of control gate electrodes CG cover the upper surface and the side surface of the fin FA via a gate insulation film GF1 and a gate insulation film GF2, respectively, and are also formed over the element isolation part STI.

An n type diffusion region MD which is formed in the fin FA on the control gate electrode CG side, and is a part of the drain region, and an n type diffusion region MS which is formed in the fin FA on the memory gate electrode MG side, and is a part of the source region are formed in such a manner as to interpose the part of the fin FA covered with the control gate electrode CG and the memory gate electrode MG in the X direction. That is, in the X direction, one control gate electrode CG and one memory gate electrode MG are each situated between the diffusion region MS and the diffusion region MD.

Further, the diffusion region MD is formed between the two control gate electrodes CG adjacent to each other in the X direction. The diffusion region MS is formed between the two memory gate electrodes MG adjacent to each other in the X direction. Thus, two memory cells MC adjacent to each other in the X direction share the diffusion region MD or the diffusion region MS. The two memory cells MC sharing the diffusion region MD are line symmetrical in the X direction across the diffusion region MD as the axis. The two memory cells MC sharing the diffusion region MS are line symmetrical in the X direction across the diffusion region MS as the axis.

Further, an n type extension region EXD having a lower impurity concentration than that of the diffusion region MD is formed as a part of the drain region in the fin FA on the control gate electrode CG side. An n type extension region EXS having a lower impurity concentration than that of the diffusion region MS is formed as a part of the source region in the fin FA on the memory gate electrode MG side. The extension region EXD is coupled to the diffusion region MD, and extends to under the sidewall spacer SW on the control gate electrode CG side. The extension region EXS is coupled to the diffusion region MS, and extends to under the sidewall spacer SW on the memory gate electrode MG side.

The memory cell MC of the present embodiment is a MISFET having the memory gate electrode MG, the gate insulation film GF1, the control gate electrode CG, the gate insulation film GF2, the diffusion region MD, the extension region EXD, the diffusion region MS, and the extension region EXS, and is a nonvolatile memory cell.

Over each memory cell MC, interlayer insulation films IL1 and IL2 are formed. In the interlayer insulation films IL1 and IL2, plugs PG are formed. Incidentally, in FIGS. 2 and 3, the interlayer insulation films IL1 and IL2 are not shown. The plugs PG are provided to electrically couple the diffusion region MD and the diffusion region MS of each memory cell MC with the wire M1 to be coupled to a bit line, and the wire M1 to be coupled to a source line, respectively.

Below, referring to FIG. 4, the cross sectional structure of the semiconductor device of the present embodiment will be described in details. As described above, FIG. 4 is a cross sectional view corresponding to line A-A and line B-B of FIG. 2. The cross sectional view along line A-A shows two memory cells MC adjacent to each other in the X direction, and the cross sectional view along line B-B shows two fins FA to be the drain region.

In the semiconductor substrate SB including the fins FA, a well region PW of a semiconductor region having a p type conductivity is formed.

At the upper part of the fin FA projecting from the element isolation part STI, over the upper surface of the fin FA, the memory gate electrode MG is formed via the gate insulation film GF1, and the control gate electrode CG is formed via the gate insulation film GF2. In the X direction, the gate insulation film GF1 and the gate insulation film GF2 are interposed between the memory gate electrode MG and the control gate electrode CG. The control gate electrode CG and the memory gate electrode MG are electrically isolated from each other by the gate insulation film GF1 and the gate insulation film GF2. Further, the gate insulation film GF1 is continuously formed in such a manner as to cover both the side surfaces and the bottom surface of the memory gate electrode MG. The gate insulation film GF2 is continuously formed in such a manner as to cover both the side surfaces and the bottom surface of the control gate electrode CG.

The gate insulation film GF1 is formed of a lamination film of an insulation film X1, a charge accumulation layer CSL formed over the insulation film X1, and an insulation film X2 formed over the charge accumulation layer CSL. The insulation film X1 is, for example, a silicon oxide film formed by thermally oxidizing the upper surface and the side surface of the fin FA, and has a film thickness of about 4 nm. The charge accumulation layer CSL is a trapping insulation film, and is, for example, an insulation film containing hafnium (Hf) and silicon (Si), and has a film thickness of about 4 nm. In the present embodiment, as the charge accumulation layer CSL, a hafnium silicate film (HfSiO film) is representatively exemplified. The insulation film X2 is, for example, an insulation film containing aluminum (Al), and has a film thickness of about 5 nm. In the present embodiment, as the insulation film X2, an alumina film (AlO film) is representatively exemplified. Such a charge accumulation layer CSL and insulation film X2 are each formed of a metal oxide film, and is a so-called high dielectric constant film (High-k film) of an insulation material film having a higher dielectric constant than that of silicon oxide.

The charge accumulation layer CSL is a film provided for accumulating data of the memory cell MC, and is an insulation film having a trap level capable of holding electric charges. Incidentally, in order to increase the trap level, another insulation film having a trap level such as a silicon nitride film may be formed between the insulation film X1 and the charge accumulation layer CSL.

Incidentally, for the charge accumulation layer CSL, there may be used a hafnium oxide film (HfO₂ film), a zirconium oxide film (ZrO₂ film), a zirconium oxynitride film (ZrON film), an aluminum nitride film (AlN film), a hafnium oxynitride film (HfON film), an aluminum oxide film (Al₂O₃ film), a hafnium / aluminate film (HfAlO₂ film), a yttrium oxide film (Y₂O₃ film), a terbium oxide film (Tb₂O₃ film), a tantalum oxide film (Ta₂O₅ film), a molybdenum oxide film (MoOx film), a praseodymium oxide film (Pr₂O₃ film), a niobium oxide film (Nb₂O₃ film), an erbium oxide film (Er₂O₃ film), a strontium titanate film (SrTiO₂ film), or a barium titanate film (BaTiO₃ film), or a lamination film thereof in place of a hafnium silicate film (HfSiO film),.

The insulation film X2 is the film provided for improving the breakdown voltage between the charge accumulation layer CSL and the memory gate electrode MG. For the insulation film X2, a silicon oxide film may be used, but the high dielectric constant film is applied in order to increase the silicon oxide equivalent thickness, and decrease the physical film thickness.

Incidentally, for the insulation film X2, in place of an alumina film (AlO film), a hafnium oxide film (HfO₂ film), a zirconium oxide film (ZrO₂ film), a tantalum oxide film (Ta₂O₅ film), a lanthanum oxide film (La₂O₃ film), a strontium titanate film (SrTiO₂ film), a hafnium silicate film (HfSiO film), a zirconium oxynitride silicate film (ZrSiON film), a hafnium nitride silicate film (HfSiON film), a yttrium oxide film (Y₂O₃ film), a gallium oxide film (Ga₂O₃ film), a tantalum oxide film (Ta₂O₅ film), a gallium aluminum oxide film (GaAlO₃ film), a zirconium silicate film (ZrSiO₄ film), an aluminum nitride film (AlN film), or an aluminum gallium ni tride film (AlGaN film), or a lamination film thereof may be used.

Further, in the accompanying drawings of the present embodiment, for simplification of description, the insulation film X1, the charge accumulation layer CSL, and the insulation film X2 are not particularly shown. The lamination film is shown as the gate insulation film GF1.

The memory gate electrode MG is, for example, a conductive film formed of a polycrystal silicon film having an n type conductivity. Further, over the memory gate electrode MG, a silicide layer SI2 is formed. The silicide layer SI2 is formed of, for example, nickel silicide (NiSi), nickel platinum silicide (NiPtSi), or cobalt silicide (CoSi₂).

The gate insulation film GF2 is formed of a metal oxide film, and is a so-called high dielectric constant film (High-k film) of an insulation material film having a higher dielectric constant than that of silicon oxide. The gate insulation film GF2 is, for example, an oxide film containing hafnium, an oxide film containing zirconium, an oxide film containing aluminum, an oxide film containing tantalum, or an oxide film containing lanthanum, and has a film thickness of 1 to 2 nm. Specifically, the gate insulation film GF2 is a hafnium oxide film (HfO₂ film), a zirconium oxide film (ZrO₂ film), an aluminum oxide film (Al₂O₃ film), a tantalum oxide film (Ta₂O₅ film), or a lanthanum oxide film (La₂O₃ film). Further, a silicon oxide film having a film thickness of about 1 nm may be formed as an insulation film for stabilizing the interface level between the gate insulation film GF2 and the fin FA.

The control gate electrode CG is formed of, for example, a monolayer metal film formed of a tantalum nitride film, a titanium aluminum film, a titanium nitride film, a tungsten film, or an aluminum film, or a lamination film of the films appropriately stacked.

The side surface of the memory gate electrode MG on the source region side of the memory cell MC is covered with a sidewall spacer SW via the gate insulation film GF1. Whereas, the side surface of the control gate electrode CG on the drain region side of the memory cell MC is covered with a sidewall spacer SW via the gate insulation film GF2. The sidewall spacer SW is formed of, for example, a monolayer insulation film formed of a silicon nitride film, or a lamination structure of a silicon nitride film and a silicon oxide film.

In the region of the fin FA exposed from the sidewall spacer SW, a trench is provided. The bottom of the trench is situated a little higher than the surface of the element isolation part STI. In the trench, an epitaxial layer EP is formed. As shown in the A-A cross section of FIG. 4, the epitaxial layer EP is formed in such a manner as to fill the inside of the trench, and is formed up to a higher position than the surface of the fin FA at which the memory gate electrode MG and the control gate electrode CG are formed. Further, as shown in the B-B cross section of FIG. 4, each epitaxial layer EP is formed by starting from the fin FA, and growing in the upward direction and the sideward direction, and is formed in such a manner that the adjacent epitaxial layers EP are not in contact with each other.

The entire epitaxial layer EP is doped with an n type impurity. Accordingly, the epitaxial layer EP becomes the diffusion region MD of a part of the drain region of the memory cell MC, or the diffusion region MS of a part of the source region of the memory cell MC. Provision of such an epitaxial layer EP can increase the contact area between the diffusion region MD and the diffusion region MS, and the plug PG described later.

In the fin FA, an extension region EXD and an extension region EXS of n type impurity regions are formed in such a manner as to surround the epitaxial layers EP of the diffusion region MD and the diffusion region MS. The extension region EXS is coupled to the diffusion region MS, and functions as the source region of the memory cell MC. The extension region EXD is coupled to the diffusion region MD, and functions as the drain region of the memory cell MC.

As described later, as main features of the present embodiment, at the upper surface and the side surface of the fin FA projecting from the element isolation part STI, the gate insulation film GF1 including a metal oxide film such as the charge accumulation layer CSL is not formed. This can resolve the following problem: the ion implantation carried out at the time of forming the extension region EXD is blocked by the metal oxide film, so that ions do not sufficiently reach the inside of the upper part of the fin FA. That is, it is possible to resolve the following problem: the vicinity of the center of the upper part of the fin FA forming the drain region does not become an n type impurity region, and is left as a p type impurity region. Therefore, the upper part of the fin FA entirely becomes an n type impurity region. In the present embodiment, the upper part of the fin FA is formed of the extension region EXD. This can prevent the increase in resistance of the drain region. Accordingly, it is possible to suppress the following problem: the supply amount of electrons or holes supplied from the drain region is reduced during the operation of the memory cell MC. Thus, the performances of the semiconductor device can be improved.

Further, at the upper surface and the side surface of the fin A projecting from the element isolation part STI, the gate insulation film GF1 is not formed. This also prevent the growth of the epitaxial layer EP from being obstructed. Therefore, at the upper surface and the side surface of the fin FA, the epitaxial layer EP with a desired size can be formed with stability.

Over the epitaxial layer EP, a silicide layer SI1 is formed for the purpose of reducing the contact resistance with the plug PG. The silicide layer SI1 is formed of, for example, nickel silicide (NiSi), nickel platinum silicide (NiPtSi), or cobalt silicide (CoSi₂).

Over the upper surface and over the side surface of the epitaxial layer EP, and over the element isolation part STI between the adjacent epitaxial layers EP, an etching stopper film ES formed of an insulation film such as a silicon nitride film is formed. Further, a part of the etching stopper film ES is also formed over the sidewall spacer SW.

Over the etching stopper film ES, an interlayer insulation film IL1 formed of, for example, a silicon oxide film is formed. The interlayer insulation film IL1 is polished by a CMP (Chemical Mechanical Polishing) method. For this reason, the interlayer insulation film IL1 does not entirely cover the memory cell MC, so that the surface of the silicide SI2 over the memory gate electrode MG, the surface of the control gate electrode CG, the upper part of the gate insulation film GF1, the upper part of the gate insulation film GF2, the upper part of the sidewall spacer SW, and the upper part of the etching stopper film ES are exposed from the interlayer insulation film IL1.

Over the polished interlayer insulation film IL1, an interlayer insulation film IL2 formed of, for example, a silicon oxide film is formed. In the interlayer insulation film IL2, in the interlayer insulation film IL1, and in the etching stopper film ES, contact holes are formed. In each of the contact holes, a plug PG is formed. The plug PG is formed of a barrier metal film formed of, for example, a titanium film or a titanium nitride film, or a lamination film thereof, and a conductive filmmainly including tungsten. FIG. 4 shows the plugs PG electrically coupled to the diffusion region MD and the diffusion region MS via the silicide layers SI1. As shown in FIG. 2, there are also the plugs PG electrically coupled to the memory gate electrode MG and the control gate electrode CG.

Over the interlayer insulation film IL2, an interlayer insulation film IL3 is formed. In the interlayer insulation film IL3, a wiring trench is formed. In the wiring trench, a conductive film, including, for example, copper as the main component is buried. As a result, a first-layer wire M1 to be coupled to the plug PG is formed in the interlayer insulation film IL3. The structure of the first wire M1 is referred to as a so-called Damascene wiring structure.

### <Regarding operation of nonvolatile memory>

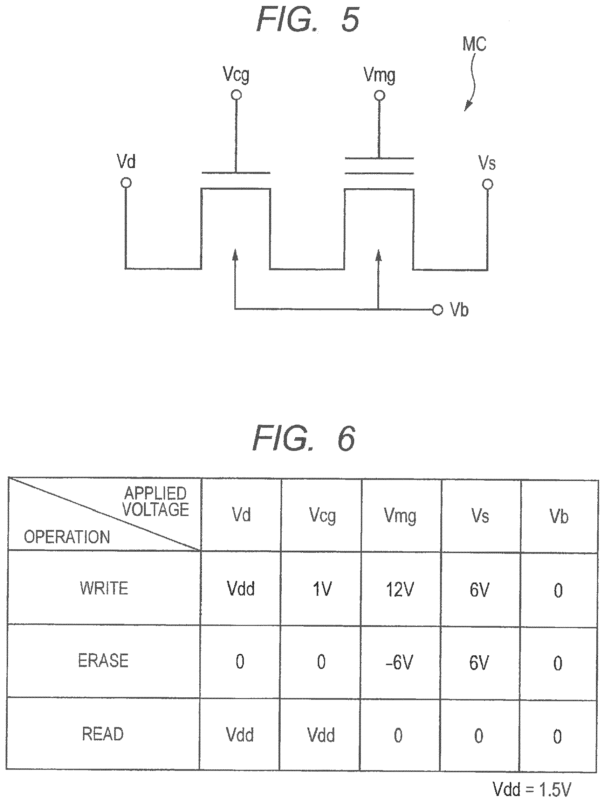

Then, the operation example of a nonvolatile memory will be described by reference to FIGS. 5 and 6.

FIG. 5 is an equivalent circuit diagram of the memory cell MC of a nonvolatile memory. FIG. 6 is the table showing one example of application conditions of voltages to each site of the selection memory cell MC at the times of "write", "erase", and "read". The table of FIG. 6 describes the voltage Vmg to be applied to the memory gate electrode MG, the voltage Vs to be applied to the diffusion region MS of the source region, the voltage Vcg to be applied to the control gate electrode CG, the voltage Vd to be applied to the diffusion region MD of the drain region, and the voltage Vb to be applied to the well region PW shown in FIG. 5 at respective times of "write", "erase", and "read".

Incidentally, those shown in the table of FIG. 6 are preferable examples of the application conditions of the voltages, and are not exclusive, and may be variously changed, if required. Further, in the present embodiment, injection of electrons into the charge accumulation layer CSL in the gate insulation film GF1 under the memory gate electrode MG is defined as "write", and injection of holes is defined as "erase".

For the write method, a write method for performing write by hot electron injection by source side injection referred to as a SSI (Source Side Injection) method can be used. For example, the voltages as shown in the row of "write" of FIG. 6 are applied to respective sites of the selection memory cell MC to perform write. Thus, electrons are injected into the charge accumulation layer CSL of the selection memory cell MC, thereby to perform write.

At this step, hot electrons are generated at the site (channel region) of the fin FA covered with the memory gate electrode MG and the control gate electrode CG, and hot electrons are injected into the charge accumulation layer CSL under the memory gate electrode MG. The injected hot electrons are trapped by the trap level in the charge accumulation layer CSL. This results in an increase in threshold voltage of the memory transistor having the memory gate electrode MG. That is, the memory transistor is put into the write state.

For the erase method, an erase method for performing erase by hot electron injection by BTBT referred to as a BTBT (Band-To-Band Tunneling) method can be used. That is, the holes generated by BTBT are injected into the charge accumulation layer CSL, thereby to perform erase. For example, the voltages as shown in the row of "erase" of FIG. 6 are applied to respective sites of the selection memory cell MC to perform erase. Thus, holes are generated by the BTBT phenomenon, thereby to accelerate the electric field. Accordingly, holes are injected into the charge accumulation layer CSL of the selection memory cell MC, resulting in the reduction of the threshold voltage of the memory transistor. That is, the memory transistor is put into the erase state.

For read, for example, the voltages as shown in the row of "read" of FIG. 6 are applied to respective sites of the selection memory cell MC to perform read. The voltage Vmg to be applied to the memory gate electrode MG at the time of read is set at a value between the threshold voltage of the memory transistor in the write state and the threshold voltage of the memory transistor in the erase state. As a result, it is possible to discriminate between the write state and the erase state.

### <Regarding manufacturing steps of semiconductor device>

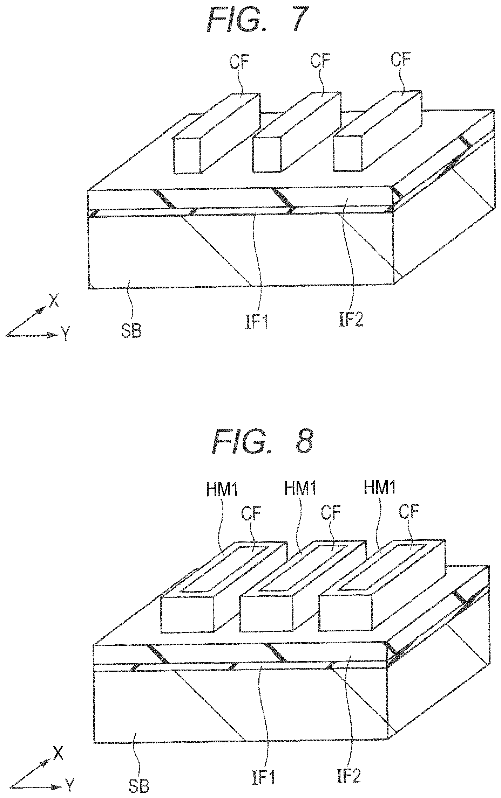

Below, referring to FIGS. 7 to 27, a method for manufacturing the semiconductor device of the present embodiment will be described.

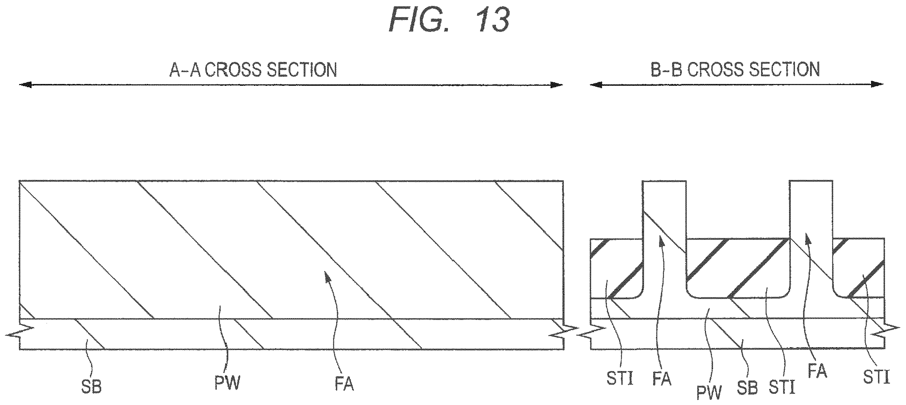

First, referring to FIGS. 7 to 12, manufacturing steps of the fin FA will be described. Incidentally, FIGS. 7 to 12 are each a perspective view of the semiconductor device of the present embodiment during a manufacturing step. FIGS. 13 to 27 are each a cross sectional view of the semiconductor device of the present embodiment during a manufacturing step.

As shown in FIG. 7, a semiconductor substrate SB is provided. Over the main surface of the semiconductor substrate SB, an insulation film IF1, an insulation film IF2, and a conductive film CF are sequentially formed. The semiconductor substrate SB is formed of, for example, a p type single crystal silicon having a specific resistance of about 1 to 10 Ωcm. The insulation film IF1 is formed of, for example, a silicon oxide film, and can be formed using, for example, a thermal oxidation method or a CVD (Chemical Vapor Deposition) method. The film thickness of the insulation film IF1 is about 2 to 10 nm. The insulation film IF2 is formed of, for example, a silicon nitride film, and is formed by, for example, a CVD method. The film thickness of the insulation film IF2 is about 20 to 100 nm. The conductive film CF is formed of, for example, a silicon film, and is formed by, for example, a CVD method. The film thickness of the conductive film CF is, for example, 20 to 200 nm. Then, using a photolithography technology and an etching method, the conductive film CF is processed. As a result, over the insulation film IF2, a plurality of patterns of the conductive film CF extending in the X direction are formed side by side in the Y direction.

Then, as shown in FIG. 8, a hard mask HM1 covering the side surface of each of the plurality of conductive films CF is formed. Herein, for example, over the semiconductor substrate SB, a silicon oxide film having a film thickness of 10 to 40 nm is formed using a CVD method. Then, dry etching is performed as anisotropic etching. As a result, respective upper surfaces of the insulation film IF2 and the conductive films CF are exposed, thereby to form the hard masks HM1 left at the side surfaces of the conductive films CF. The hard masks HM1 do not fully full between the adjacent conductive films CF, and are each formed in a ring in such a manner as to surround each conductive film CF.

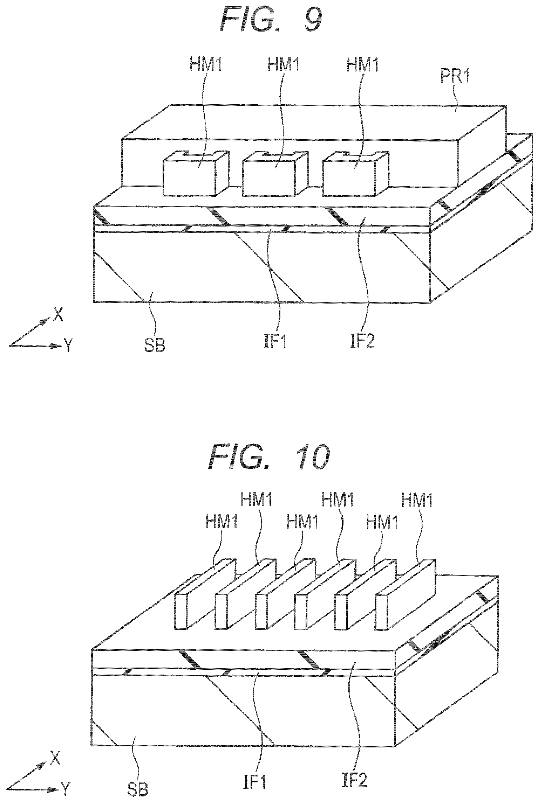

Then, as shown in FIG. 9, using a wet etching method, the conductive films CF are removed. As a result, over the insulation film IF2, the annular hard masks HM1 are left. Then, a resist pattern PR1 covering a part of each hard mask HM1 is formed. The resist pattern PR1 is the pattern covering the portions of each hard mask HM1 extending in the X direction, and exposing the ends of the portions extending in the X direction, and the portions extending in the Y direction. In other words, the opposite ends of each hard mask HM1 in the X direction are exposed from the resist pattern PR1.

Then, as shown in FIG. 10, etching is performed using the resist pattern PR1 as a mask, thereby to remove portions of the hard masks HM1. As a result, only the portions of the hard masks HM1 extending in the X direction are left. That is, over the insulation film IF2, a plurality of hard masks HM1 of patterns extending in the X direction are arranged side by side in the Y direction. Thereafter, the resist pattern PR1 is removed by an ashing treatment, or the like.

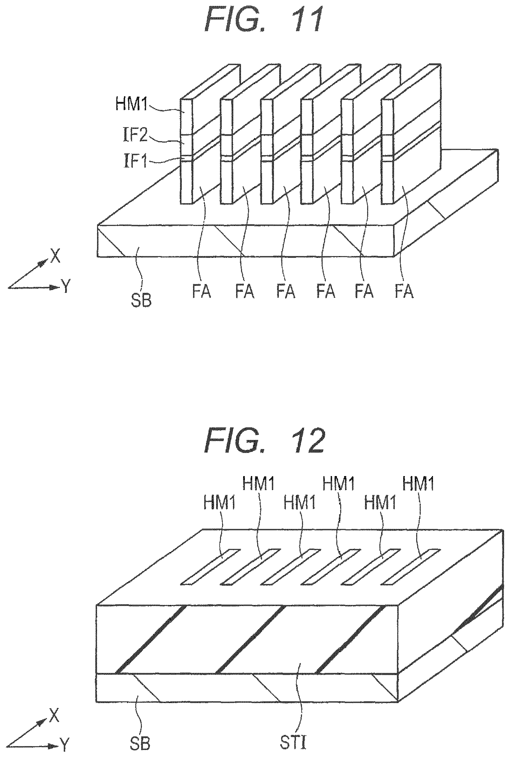

Then, as shown in FIG. 11, using the hard masks HM1 as a mask, the insulation film IF2, the insulation film IF1, and the semiconductor substrate SB are subjected to anisotropic etching. This results in the formation of the fins FA of portions of the semiconductor substrate SB processed into a plate shape (wall shape) immediately under the hard masks HM1. Herein, the main surface of the semiconductor substrate SB in the region exposed from the hard masks HM1 is dug to 100 to 250 nm, resulting in the formation of the fins FA having a height from the main surface of the semiconductor substrate SB of 100 to 250 nm.

Then, as shown in FIG. 12, over the semiconductor substrate SB, an insulation film formed of a silicon oxide film or the like is deposited in such a manner as to fill between the fins FA, the insulation films IF1, the insulation films IF2, and the hard masks HM1. Subsequently, the insulation film is subjected to a polishing treatment by a CMP method, thereby to expose the upper surfaces of the hard masks HM1. This results in the formation of an element isolation part STI formed of the insulation film.

The manufacturing steps following FIG. 12 will be described by reference to FIGS. 13 to 27. In FIGS. 13 to 27, each left-hand drawing is a cross sectional view corresponding to line A-A of FIG. 2, and each right-hand drawing is a cross sectional view corresponding to line B-B of FIG. 2.

As shown in FIG. 13, the hard masks HM1, the insulation films IF1, and the insulation films IF2 are removed. Subsequently, the upper surface of the element isolation part STI is subjected to an etching treatment, so that the upper surface of the element isolation part STI is retreated in the height direction. As a result, the portions of the side surfaces and the upper surfaces of the fins FA are exposed. Incidentally, in the present embodiment, the portion of each fin FA situated at a higher position than the surface of the element isolation part STI retreated in this step may be referred to as the upper part of the fin FA, and the portion of each fin FA situated at a lower position than the surface of the element isolation part STI may be referred to as the lower part of the fin FA.

Then, using a photolithography method, an ion implantation method, and the like, the main surface of the semiconductor substrate SB is doped with an impurity, thereby to form a p type well region PW in the fins FA. The impurity for forming the p type well region PW is, for example, boron (B) or boron difluoride (BF₂). The well region PW is formed extending in the whole of the fins FA and a part of the semiconductor substrate SB.

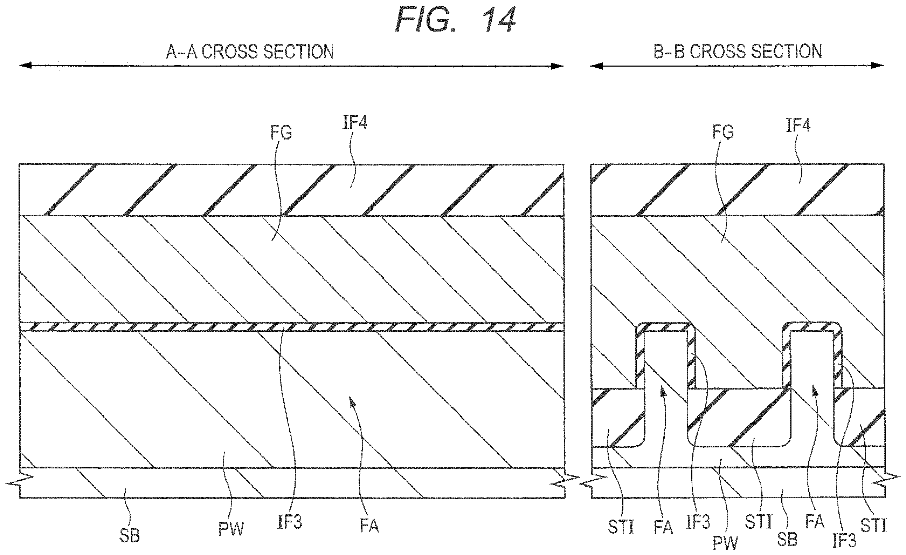

FIG. 14 shows the formation step of the insulation film IF3, the conductive film FG, and the insulation film IF4.

First, the insulation film IF3 covering the fins FA is formed. The insulation film IF3 is a silicon oxide film formed by, for example, a thermal oxidation method, and has a film thickness of about 2 nm. Then, the conductive film FG formed of, for example, a polycrystal silicon film is deposited over the semiconductor substrate SB via the insulation film IF3 in such a manner as to cover the upper surfaces and the side surfaces of the fins FA using, for example, a CVD method. Then, using, for example, a CMP method, the upper surface of the conductive film FG is planarized. Upon completion of the polishing step, the upper surfaces and the side surfaces of the fins FA along B-B cross section are covered with the conductive film FG via the insulation film IF3. Then, using, for example, a CVD method, over the conductive film FG, the insulation film IF4 formed of, for example, a silicon nitride film is formed.

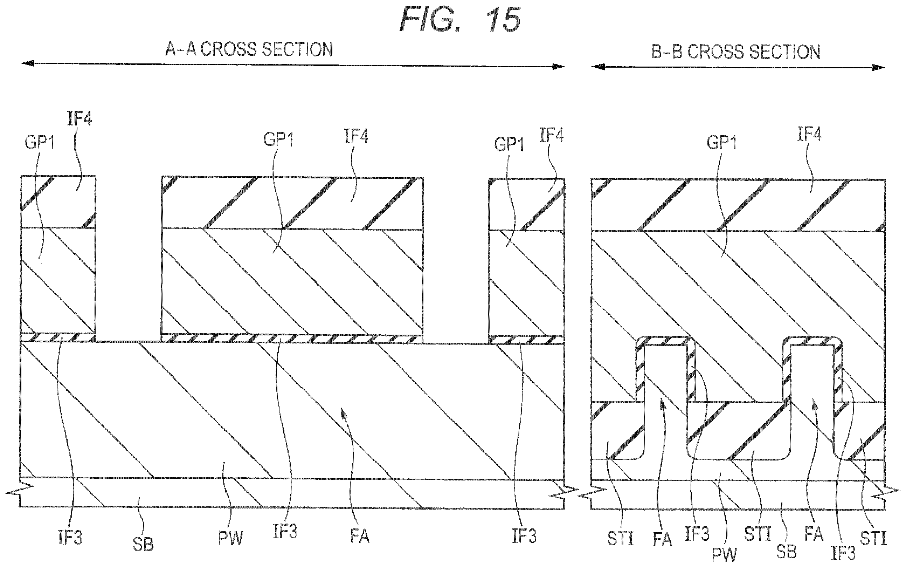

FIG. 15 shows the formation step of the gate pattern GP1.

First, using a photolithography method and a dry etching method, the insulation film IF4 is selectively patterned. Then, using the patterned insulation film IF4 as a mask, the conductive film FG is dry etched, thereby to form a gate pattern (dummy pattern) GP1. That is, the conductive film FG is patterned, so that the gate pattern GP1 is formed. Then, the insulation film IF3 exposed from the gate pattern GP1 is removed, so that the insulation film IF3 is left under the gate pattern GP1. Incidentally, the gate pattern GP1 extends in the direction (the Y direction) orthogonal to the direction of extension of the fin FA (the X direction).

It is important that the gate pattern GP1 is not processed in the final shape (second shape) of the control gate electrode CG, but is processed in the intermediate shape (first shape) in the steps. That is, it is important that the conductive film FG is processed so as to prevent the drain region of the memory cell MC from being opened. In other words, the upper surface and the side surface of the fin FA along B-B cross section is covered with the gate pattern GP1 and the insulation film IF3 until the gate pattern GP2 in the final shape of the control gate electrode CG is formed in a later step.

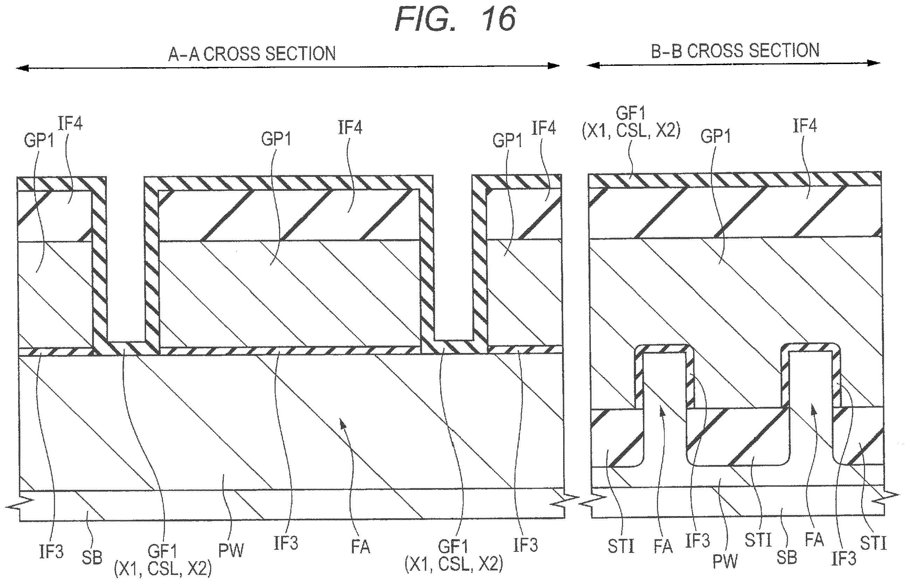

FIG. 16 shows the formation step of the gate insulation film GF1 having an insulation film X1, a charge accumulation layer CSL, and an insulation film X2.

First, the insulation film X1 is formed in such a manner as to cover the gate pattern GP1 and the insulation film IF4. The insulation film X1 is formed using, for example, a thermal oxidation method or a CVD method, is, for example, a silicon oxide film, and has a film thickness of about 4 nm.

In A-A cross section, the insulation film X1 is formed along the upper surface and the side surface of each gate pattern GP1. At this step, in the region exposed from the gate pattern GP1, the insulation film X1 is formed at the upper surface and the side surface of the fin FA. The region is the region where the memory gate electrode MG is formed later.

Whereas, in B-B cross section, the fin FA is covered with the gate pattern GP1, and hence the insulation film X1 is not in direct contact with the fin FA.

Then, for example, using a CVD method or an ALD (Atomic Layer Deposition) method, over the insulation film X1, the charge accumulation layer CSL is formed. The charge accumulation layer CSL is an insulation film having a trap level capable of holding electric charges, is, for example, an insulation film containing hafnium (Hf) and silicon (Si), and has a film thickness of about 4 nm. In the present embodiment, as the charge accumulation layer CSL, a hafnium silicate film (HfSiO film) is representatively exemplified. Then, for example, using a CVD method or an ALD method, over the charge accumulation layer CSL, the insulation film X2 is formed. The insulation film X2 is, for example, an insulation film containing aluminum (Al) such as an aluminum oxide film (AlO film), and has a film thickness of about 5 nm. The charge accumulation layer CSL and the insulation film X2 are each formed of a metal oxide film, and is a so-called high dielectric constant film (High-k film) of an insulation material film having a higher dielectric constant than that of silicon oxide.

Incidentally, for the charge accumulation layer CSL, in place of a hafnium silicate film (HfSiO film), there may be used a hafnium oxide film (HfO₂ film), a zirconium oxide film (ZrO₂ film), a zirconium oxynitride film (ZrON film), an aluminum nitride film (AlN film), a hafnium oxynitride film (HfON film), an aluminum oxide film (Al₂O₃ film), a hafnium / aluminate film (HfAlO₂ film), a yttrium oxide film (Y₂O₃ film), a terbium oxide film (Tb₂O₃ film), a tantalum oxide film (Ta₂O₅ film), a molybdenum oxide film (MoOx film), a praseodymium oxide film (Pr₂O₃ film), a niobium oxide film (Nb₂O₃ film), an erbium oxide film (Er₂O₃ film), a strontium titanate film (SrTiO₂ film), or a barium titanate film (BaTiO₃ film), or a lamination film thereof.

Incidentally, for the insulation film X2, in place of an alumina film (AlO film), there may be used a hafnium oxide film (HfO₂ film), a zirconium oxide film (ZrO₂ film), a tantalum oxide film (Ta₂O₅ film), a lanthanum oxide film (La₂O₃ film), a strontium titanate film (SrTiO₂ film), a hafnium silicate film (HfSiO film), a zirconium oxynitride silicate film (ZrSiON film), a hafnium nitride silicate film (HfSiON film), a yttrium oxide film (Y₂O₃ film), a gallium oxide film (Ga₂O₃ film), a tantalum, oxide film (Ta₂O₅ film), a gallium aluminum oxide film (GaAlO₃ film), a zirconium silicate film (ZrSiO₄ film), an aluminum nitride film (AlN film), or an aluminum gallium nitride film (AlGaN film), or a lamination film thereof.

From the description up to this point, the gate insulation film GF1 having the insulation film X1, the charge accumulation layer CSL, and the insulation film X2 is formed over the upper surface and over the side surface of each gate pattern GP1, and over the upper surface and over the side surface of the fin FA between the gate patterns GF1.

Further, at the time of formation of the gate insulation film GF1, the upper surface and the side surface of the fin FA along B-B cross section are covered with the gate pattern GF1 and the insulation film IF3. For this reason, the gate insulation film GF1 is not formed over the upper surface and over the side surface of the fin FA along B-B cross section.

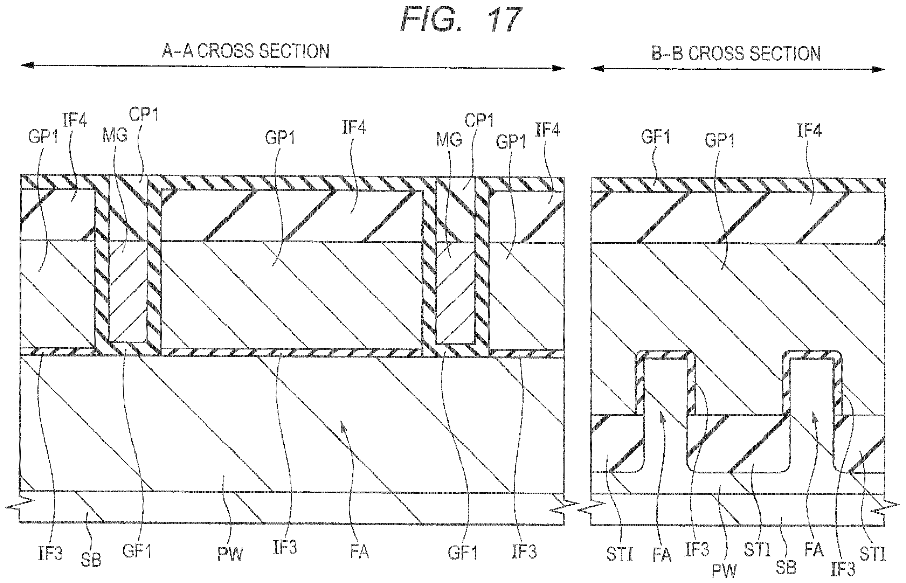

FIG. 17 shows the formation step of the memory gate electrode MG and the cap film CP1.

First, over the gate insulation film GF1, using, for example, a CVD method, for example, a polycrystal silicon film is deposited as a conductive film for the memory gate electrode MG. Thereafter, the conductive film is polished by a CMP method, thereby to form the memory gate electrode MG over the gate insulation film GF1 in such a manner as to fill between the adjacent gate patterns GP1. Subsequently, dry etching is performed, thereby to retreat the surface of the memory gate electrode MG. Incidentally, the memory gate electrode MG extends in the Y direction.

Then, over the retreated memory gate electrode MG and over the gate insulation film GF1, for example, a silicon oxide film is formed as the insulation film for the cap film CP1 by, for example, a CVD method. Then, the insulation film is subjected to a polishing treatment by a CMP method, and anisotropic etching, thereby to form the cap film CP1 over the memory gate electrode MG. As a result, the surface of the cap film CP1 is at almost the same height as that of the surface of the gate insulation film GF1.

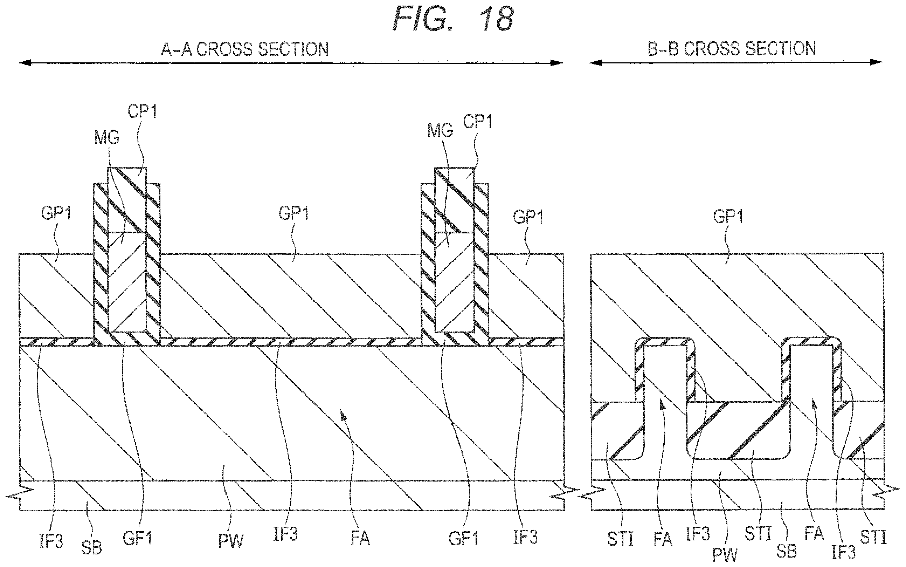

FIG. 18 shows the removal step of a part of the gate insulation film GF1 and the insulation film IF4.

First, the gate insulation film GF1 formed over the upper surface of each gate pattern GP1 is removed by anisotropic etching. At this step, the gate insulation film GF1 is left at the bottom surface and both the side surfaces of the memory gate electrode MG. Then, the insulation film IF4 is removed by anisotropic etching and wet etching. Then, the exposed gate pattern GP1 is subjected to anisotropic etching, thereby to retreat the surface of the gate pattern GP1. The steps cause the memory gate electrode MG and the cap film CP1 to project from the gate pattern GP1.

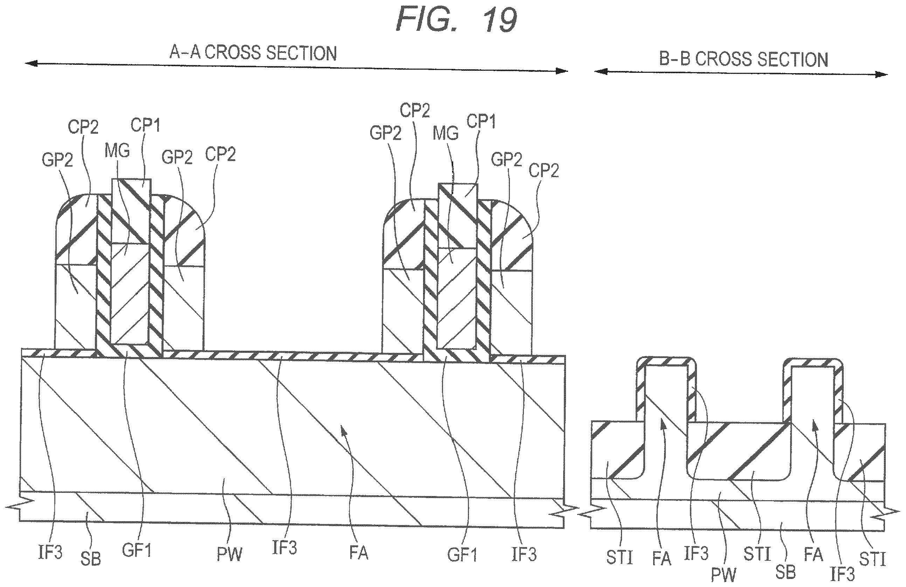

FIG. 19 shows the formation step of the cap film CP2.

First, for example, a silicon nitride film is formed as an insulation film for the cap film CP2 in such a manner as to cover the gate pattern GP1 with the surface retreated, using, for example, a CVD method. Then, the insulation film is subjected to anisotropic etching, thereby to form the cap films CP2 each in a spacer shape at both the side surfaces of the projecting memory gate electrode MG and cap film CP1 via the gate insulation film GF1, respectively.

Then, using the cap film CP2 as a mask, the gate pattern GP1 is subjected to anisotropic etching. As a result, a part of the gate pattern GP1 exposed from the cap film CP2 is removed, resulting in the formation of the gate pattern GP2 formed of the remaining gate pattern GP1. The gate pattern GP2 is formed along the memory gate electrode MG, and extends in the Y direction.

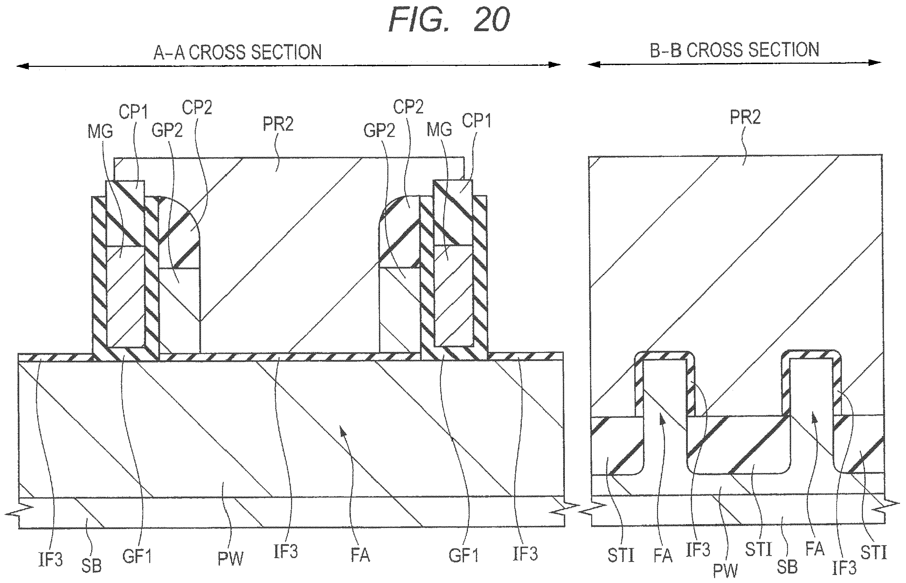

FIG. 20 shows a step of removing one of the gate patterns GP2 formed at both the side surfaces of the memory gate electrode MG.

First, a resist pattern PR2 covering the gate pattern GP2 formed at one side surface of the memory gate electrode MG is formed. Then, using the resist pattern PR2 as a mask, dry etching and wet etching are performed, thereby to remove the cap film CP2 and the gate pattern GP2 not covered with the resist pattern PR2. As a result, the gate pattern GP2 is left only on the drain region side of the memory cell MC. Thereafter, the resist pattern PR2 is removed by an ashing treatment or the like.

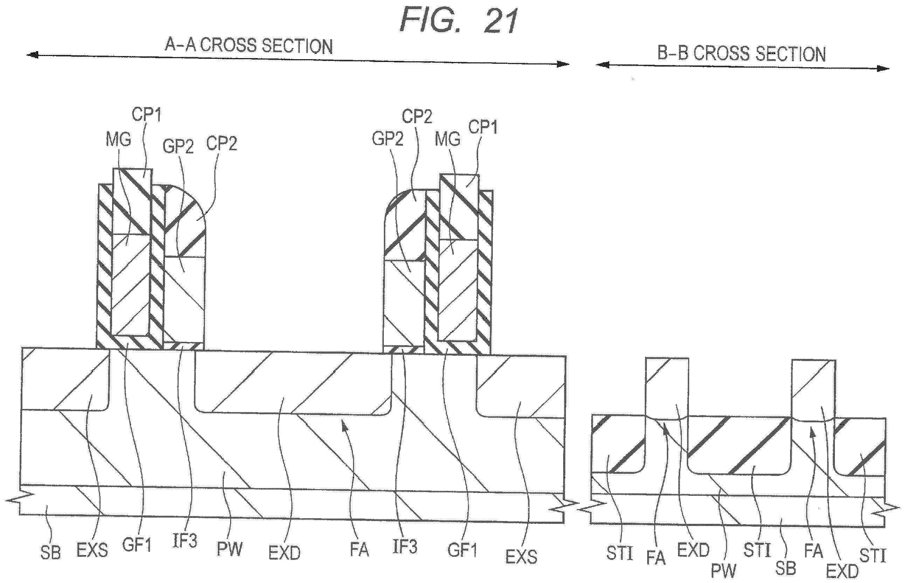

FIG. 21 shows the formation step of the extension region EXD and the extension region EXS.

First, by a photolithography method and an ion implantation method, for example, arsenic (As) or phosphorus (P) is doped into the fin FA. As a result, the n type extension region (impurity region) EXD and the n type extension region (impurity region) EXS are formed in the fins FA. The extension region EXD and the extension region EXS are formed in self-alignment with the gate pattern GP2 and the memory gate electrode MG. In other words, an n type impurity is implanted into the upper surface and the side surface of each fin FA exposed from the gate pattern GP2 and the memory gate electrode MG.

Thereafter, for activation of the impurity, the semiconductor substrate SB is subjected to a heat treatment. As a result, as shown in A-A cross section, the extension region EXD and the extension region EXS are formed at both the side surfaces of the gate pattern GP2 and the memory gate electrode MG in such a manner as to interpose the gate pattern GP2 and the memory gate electrode MG therebetween. Further, as shown in B-B cross section, the extension region EXD is formed not only at the entire upper part of the fin FA, but also at a part of the lower part of the fin FA. Subsequently, the insulation film IF3 exposed from the gate pattern GP2 is removed using wet etching, or the like.

Incidentally, the ion implantation is performed using oblique ion implantation, and is performed, for example, at a tilt angle of 20 degrees or more, and 40 degrees or less with respect to the normal to the semiconductor substrate SB. Incidentally, the oblique ion implantation is performed four times, and is performed by rotating the semiconductor substrate SB by 90 degrees per time.

As main features of the present embodiment, mention may be made of the fact that the gate insulation film GF1 including a metal oxide film such as the charge accumulation layer CSL is not formed at the upper surface and the side surface of the fin FA forming the drain region. This is because the regions of the fins FA to be the drain region and the source region of the memory cell MC have been covered with the gate pattern GP1 up to the formation of the extension region EXD and the extension region EXS.

### <Comparison between the semiconductor device of the present embodiment and a semiconductor device of Study Example in the memory cell MC>

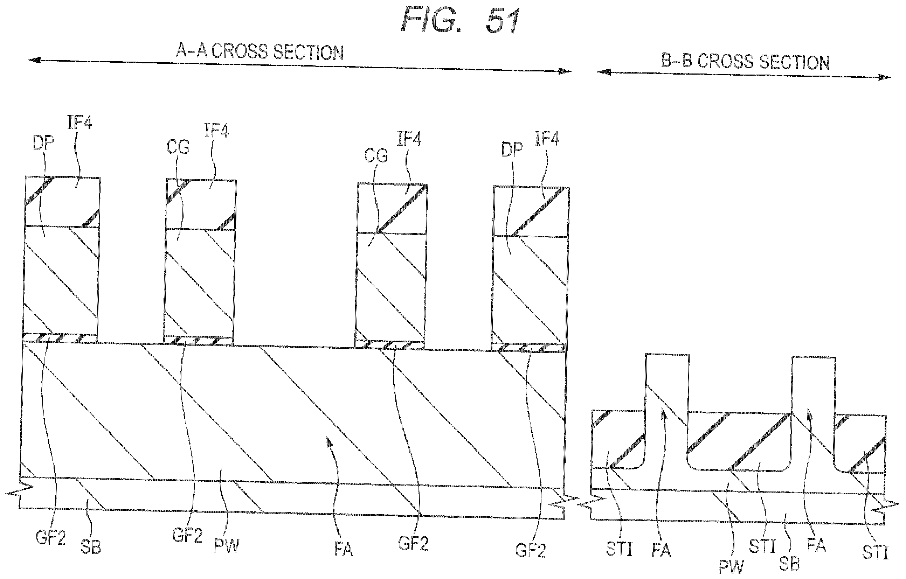

FIGS. 51 to 56 each show a semiconductor device of Study Example. Using the Study Example, findings of the present inventors will be described below. The semiconductor device of Study Example is of a novel memory cell structure tried to be formed by the present inventors by applying the technology disclosed in, for example, the Patent Document 2 to the split gate type memory cell of the fin structure as in, for example, the Patent Document 1, and further applying a metal oxide film to the charge accumulation layer CSL.

FIG. 51 shows a manufacturing step corresponding to FIG. 15 of the present embodiment. In Study Example, as distinct from the present embodiment, as shown in the A-A cross section of FIG. 51, the conductive film FG is processed into a control gate electrode CG and a dummy pattern DP. Further, under the control gate electrode CG and under the dummy pattern DP, a gate insulation film GF2 is formed. That is, in Study Example, as distinct from the gate pattern GP1 of the present embodiment, the control gate electrode CG is formed as the final shape. Therefore, as shown in the B-B cross section of FIG. 51, the fin FA to be the drain region is exposed from the control gate electrode CG.

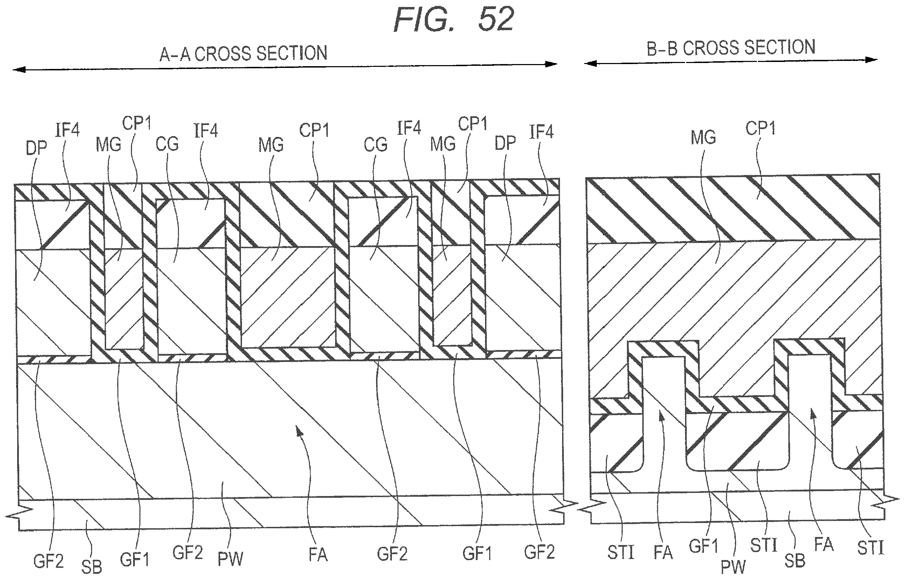

Then, as shown in the A-A cross section of FIG. 52, over the insulation film IF4, and over the side surface of the control gate electrode CG, a gate insulation film GF1 is formed. Thereafter, the memory gate electrode MG and the cap film CP1 are buried between the adjacent control gate electrodes CG, and between the control gate electrode CG and the dummy pattern DP. At this step, as shown in the B-B cross section of FIG. 52, the gate insulation film GF1 is formed over the upper surface and over the side surface of the fin FA between the control gate electrodes CG. Over the gate insulation film GF1, the memory gate electrode MG is formed. Incidentally, in Study Example, the memory gate electrode MG is a metal film such as tungsten, or a polycrystal silicon film.

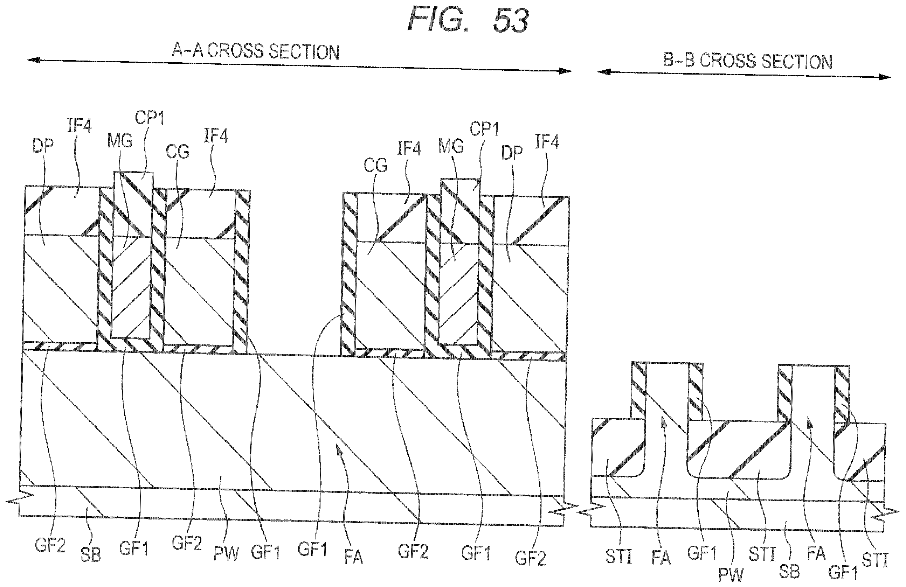

Then, as shown in the A-A cross section of FIG. 53, using a photolithography method and a dry etching method, the memory gate electrode MG formed at the portion to be the drain region of the memory cell MC is removed. Thereafter, by anisotropic etching such as dry etching, in order that the portions of the gate insulation film GF1 formed at the bottom surface and the side surface of the memory gate electrode MG are left, the portions of the gate insulation film GF1 in other regions are removed.

At this step, unfavorably, the portions of the gate insulation film GF1 over the upper surface of the insulation film IF4, and over the upper surface of the fin FA can be removed, but the portions of the gate insulation film GF1 over the side surface of the control gate electrode CG, and over the side surface of the fin FA are difficult to remove.

First, the present inventors conducted a study on removal of the gate insulation film GF1 by isotropic etching such as wet etching. As described above, in the present embodiment, as the typical example of the charge accumulation layer CSL, a hafnium silicate film (HfSiO film) is used, and as the typical example of the insulation film X2, an alumina film (AlO film) is used. However, with the current wet etching technology, unfavorably, a chemical capable of effectively removing the films, and relatively readily available has not found wide use. Further, even if wet etching is possible, the wet etching may also retreat the gate insulation film GF1 formed at the side surface of the memory gate electrode MG.

Therefore, the present inventors conducted a study on removal of the gate insulation film GF1 by anisotropic etching such as dry etching. However, as described above, with anisotropic etching, it is difficult to fully remove the gate insulation film GF1 over the side surface of the fin FA.

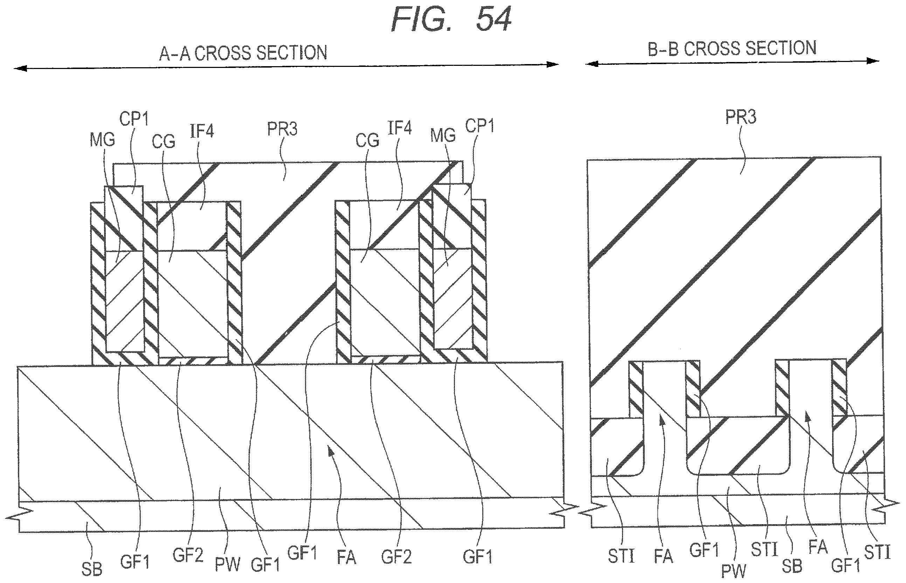

Thereafter, as shown in FIG. 54, using the resist pattern PR3 as a mask, the dummy pattern DP is removed, thereby to expose the fin FA to be the source region of the memory cell MC.

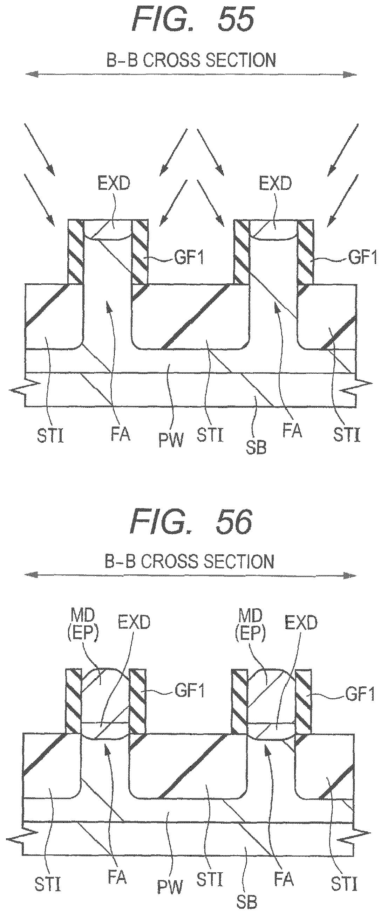

FIGS. 55 and 56 each show the problem in the step of forming the extension region EXD and the step of forming the epitaxial layer EP with the gate insulation film GF1 left over the side surface of the fin FA as in Study Example. Incidentally, FIGS. 55 and 56 each show only the B-B cross section that matters, but each do not show the A-A cross section.

FIG. 55 shows the formation step of the extension region EXD, and shows the manufacturing step corresponding to FIG. 21 of the present embodiment. Incidentally, arrows in the drawing indicate ion implantation. With the gate insulation film GF1 left over the side surface of the fin FA, oblique ion implantation for forming the extension region EXD is performed. As a result, the gate insulation film GF1 obstructs ion implantation. For this reason, as shown in FIG. 55, ions reach only the vicinity of the upper surface of the fin FA. Therefore, unfavorably, ions are not implanted into the most part of the fin FA.

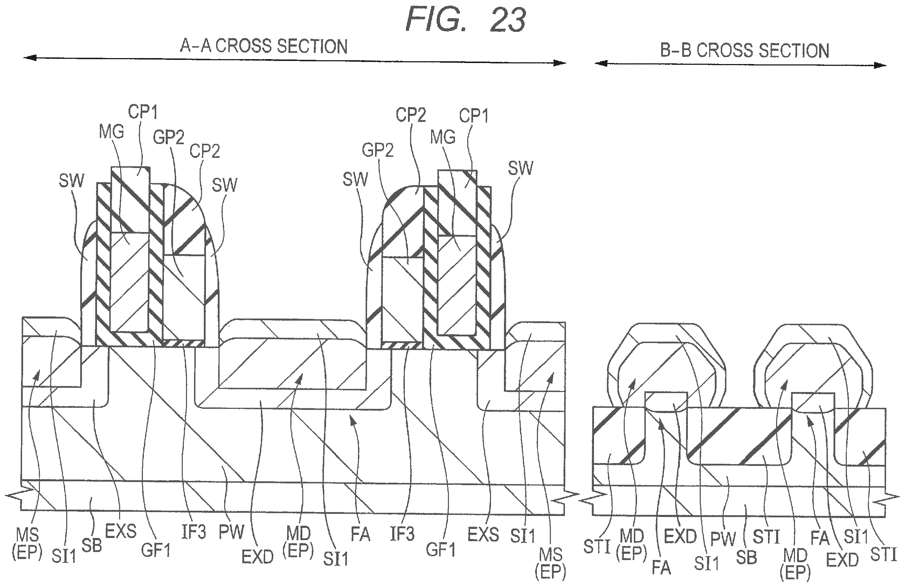

FIG. 56 shows the formation step of the epitaxial layer EP (diffusion region MD), and shows the manufacturing step corresponding to FIG. 23 of the present embodiment. Before the formation of the epitaxial layer EP, the upper part of the fin FA is retreated. At this step, the gate insulation film GF1 is left in a wall shape. In this state, epitaxial growth is performed. As a result, as shown in FIG. 56, the epitaxial layer EP grows only in the wall-shaped gate insulation film GF1. For this reason, as compared with FIG. 23 of the present embodiment, the growth of the epitaxial layer EP is largely suppressed, so that the volume of the final epitaxial layer EP becomes very small. That is, the region to be the diffusion region MD becomes very small. Therefore, the drain region has a high resistance. Thus, unfavorably, the desired characteristics of the memory cell MC cannot be obtained.

Thus, it is indicated as follows: when for the gate insulation film GF1, the charge accumulation layer CSL and the insulation film X2 formed of a metal oxide film are adopted, and the gate insulation film GF1 is applied to the fin structure, it is difficult to sufficiently ensure the performances of the memory cell MC, and problems unexpectable in the related art may be caused.

The present embodiment was invented in consideration of the foregoing problems, and can resolve the problems. That is, as described with reference to FIG. 21, in the present embodiment, up to the formation of the extension region EXD, the regions of the fin FA to be the drain region and the source region of the memory cell MC were covered with the gate pattern GP1 in the intermediated shape of the control gate electrode CG. For this reason, at the time of formation of the extension region EXD, the gate insulation film GF1 is not formed at the upper surface and the side surface of the fin FA forming the drain region. Therefore, it is possible to resolve the following problem: ion implantation performed for forming the extension region EXD is interrupted by the metal oxide film, so that ions do not sufficiently reach the inside of the upper part of the fin FA. That is, the following problem can be resolved: the vicinity of the center of the upper part of the fin FA forming the drain region does not become an n type impurity region, but is left as a p type impurity region. In the present embodiment, the upper part of the fin FA entirely becomes an n type impurity region. This can prevent the increase in resistance of the drain region, which can suppress the problem of the reduction of the amount of electrons or holes supplied from the drain region during the operation of the memory cell MC. Accordingly, the performances of the semiconductor device can be improved.

Incidentally, the growth of the epitaxial layer EP will be described by reference to FIG. 23 described later.

Up to this point, comparison between the present embodiment and Study Example is completed.

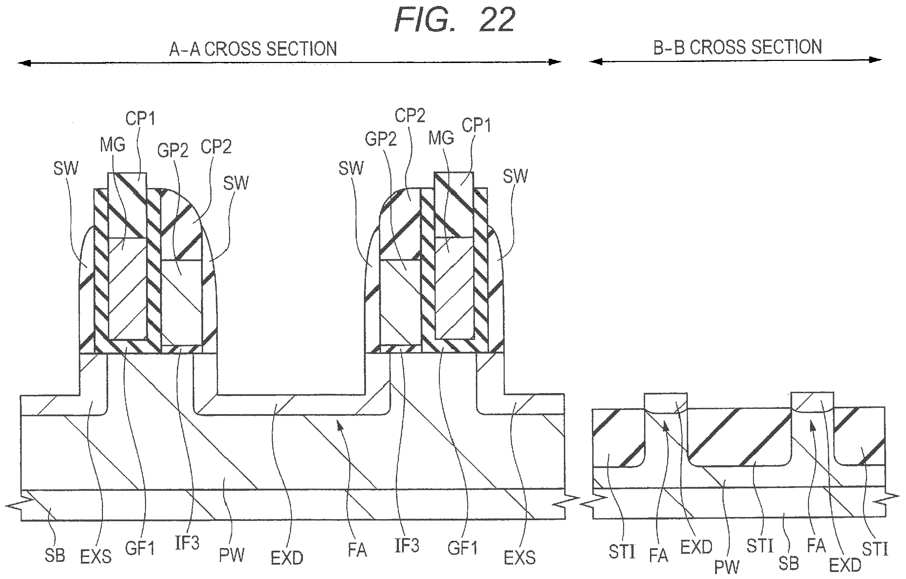

FIG. 22 shows the manufacturing step of the present embodiment following FIG. 21, and the formation step of the sidewall spacer SW and the retreating step of the fin FA.

First, an insulation film formed of, for example, silicon nitride is formed in such a manner as to cover the memory cell MC using, for example, a CVD method. Then, the insulation film is subjected to anisotropic dry etching, thereby to form sidewall spacers SW over the side surface of the gate pattern GP2, and over the side surface of the gate memory gate electrode MG via the insulation film GF1.

At this step, it is important that the sidewall spacer SW is prevented from being left over the side surface of the fin FA. When the sidewall spacer SW is left over the side surface of the fin FA at the time of the later formation step of the epitaxial layer EP, the sidewall spacer SW may become a wall to obstruct the growth of the epitaxial layer EP. That is, almost the same problem as the problem described by reference to FIG. 56 of Study Example is caused. Therefore, the sidewall spacer SW over the side surface of the fin FA is desirably removed as much as possible, and is more desirably fully removed. For this reason, in the present embodiment, anisotropic dry etching on the insulation film is performed to achieve sufficient overetching, so that the sidewall spacer SW is not left over the side surface of the fin FA.

Further, as shown in the A-A cross section of FIG. 22, the overetching makes the height of each sidewall spacer SW formed over the side surface of the gate pattern GP2, and over the side surface of the memory gate electrode MG a little lower. However, when the height of the sidewall spacer SW is too low, and the side surface of the gate pattern GP2 is exposed, the epitaxial layer EP may grow from the side surface of the gate pattern GP2 at the later formation step of the epitaxial layer EP. For this reason, the sidewall spacer SW is desirably formed in such a manner as to cover not only the side surface of the gate pattern GP2 but also the side surface of the cap film CP2. In other words, the position of the upper end of the sidewall spacer SW is lower than the upper surface of the cap film CP2, and higher than the interface between the gate pattern GP2 and the cap film CP2.

Thereafter, using the sidewall spacer SW as a mask, dry etching is performed, thereby to retreat the upper surface of the fin FA. As a result, the retreated upper surface of the fin FA is at a higher position than that of the upper surface of the element isolation part STI, and at a lower position than that of the upper surface of the fin FA immediately under the memory gate electrode MG and the gate pattern GP2.

FIG. 23 shows the formation step of the epitaxial layer EP.

Over the retreated upper surface and over the side surface of the fin FA, using an epitaxial growth method, the epitaxial layer EP (semiconductor layer EP) formed of, for example, Si (silicon) is formed. At this step, the epitaxial layer EP is grown until the upper surface of the epitaxial layer EP is at a higher position than that of the upper surface of the fin FA immediately under the memory gate electrode MG and the gate pattern GP2. Further, as shown in the B-B cross section of FIG. 23, each epitaxial layer EP is grown so as to prevent the epitaxial layers EP formed at the adjacent fins FA, respectively, from being in contact with each other.

As distinct from Study Example described by reference to FIG. 56, in the present embodiment, before the formation of the epitaxial layer EP, the gate insulation film GF1 is not formed at the upper surface and the side surface of the fin FA forming the drain region . For this reason, in the present embodiment, the wall-shaped gate insulation film GF1 is not present as in Study Example. Accordingly, the epitaxial layer EP can be grown over the upper surface and over the side surface of the fin FA with stability. Therefore, the epitaxial layer EP to be the drain region has a desirable volume, and hence the drain region will not have a high resistance. Further, a plug PG is formed over the drain region. However, large growth of the epitaxial layer EP can keep large the contact area between the epitaxial layer EP and the plug PG.

After the formation step of the epitaxial layer EP, by a photolithography method and an ion implantation method, each epitaxial layer EP is doped with an n type impurity. Then, a heat treatment for activating the impurity is carried out. As a result, the epitaxial layer EP becomes an n type impurity region. In the present embodiment, the epitaxial layer EP to be the drain region is shown as the n type diffusion region MD, and the epitaxial layer EP to be the source region is shown as the n type diffusion region MS. Incidentally, the impurity concentrations of the diffusion region MD and the diffusion region MS are larger than the impurity concentrations of the extension region EXD and the extension region EXS, respectively.

Incidentally, by mixing a gas resulting in an impurity showing an n type conductivity in the deposition gas for use in the epitaxial growth method, the epitaxial layer EP may be grown as a silicon layer containing an n type impurity. In this case, the ion implantation is unnecessary.

After the formation step of the diffusion region MD and the diffusion region MS, a low-resistance silicide layer SI1 is formed over the diffusion region MD and over the diffusion region MS by a Salicide (Self Aligned Silicide) technology.

The silicide layer SI1 can be formed specifically in the following manner. First, entirely over the main surface of the semiconductor substrate SB, by a CVD method, for example, a silicon oxide film is formed as an insulation film for forming the silicide layer SI1. Then, the insulation film is selectively patterned, thereby to open only the region where the silicide layer is formed. Then, a metal film for forming the silicide layer SI1 is formed in such a manner as to cover the entire main surface of the semiconductor substrate SB. The metal film is formed of, for example, cobalt, nickel, or nickel platinum alloy. Then, the semiconductor substrate SB is subjected to a first heat treatment at about 300 to 400°C, and then, is subjected to a second heat treatment at about 600 to 700°C. As a result, the diffusion region MD and the diffusion region MS are allowed to react with the metal film. This results in the formation of the silicide layer SI1 formed of cobalt silicide (COSi₂), nickel silicide (NiSi), or nickel platinum silicide (NiPtSi) over the diffusion region MD and over the diffusion region MS. Thereafter, the unreacted portions of the metal film are removed. Subsequently, the insulation film for forming the silicide layer SI1 is removed by wet etching.

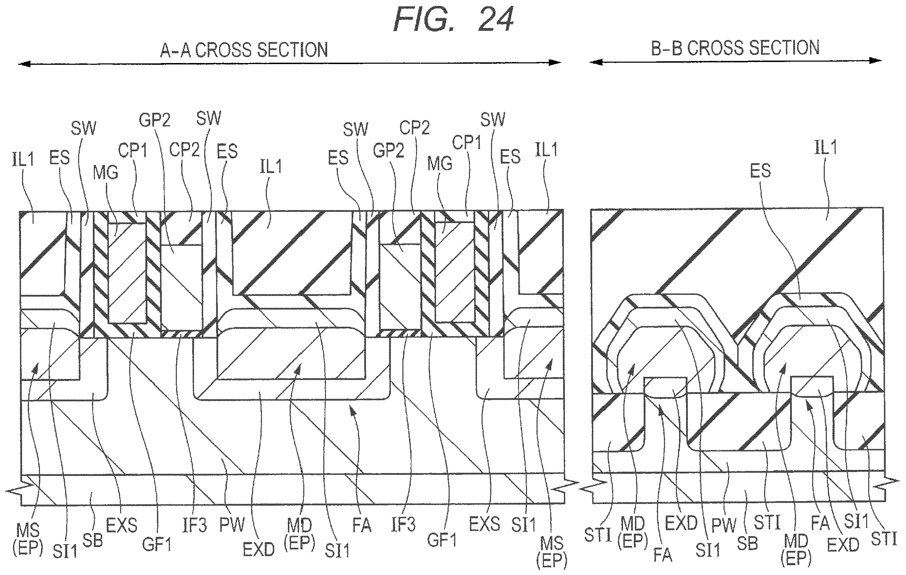

FIG. 24 shows the formation step of an etching stopper film ES and an interlayer insulation film IL1.

First, the etching stopper film (insulation film) ES formed of, for example, a silicon nitride film is formed in such a manner as to cover the memory cell MC using, for example, a CVD method. Then, over the etching stopper film ES, using, for example, a CVD method, the interlayer insulation film IL1 formed of, for example, a silicon oxide film is formed. Then, using a CMP method or the like, the interlayer insulation film IL1 is polished. Thereafter, further , the polishing treatment is continued. As a result, the etching stopper film ES, the cap film CP2 over the gate pattern GP2, and the cap film CP1 over the memory gate electrode MG are also polished.

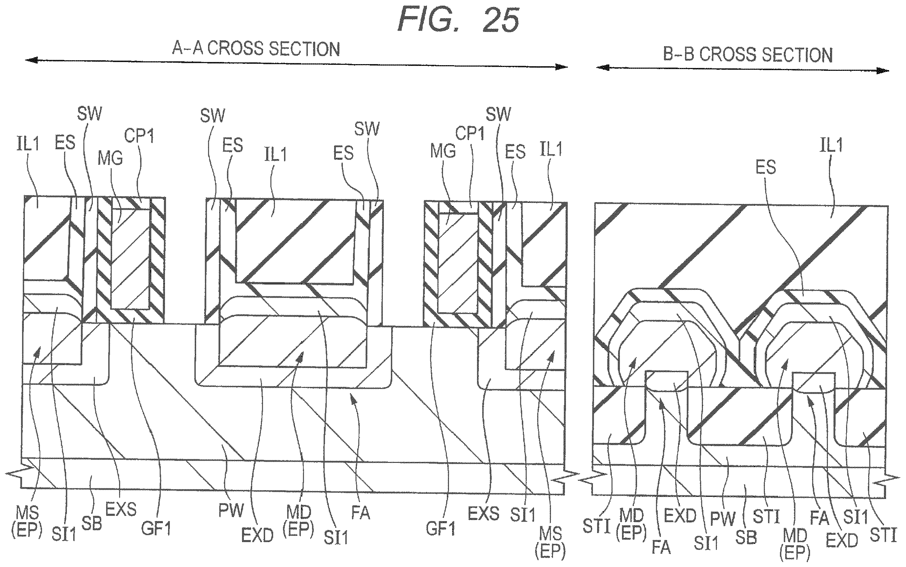

FIG. 25 shows the removal step of the cap film CP2, the gate pattern GP2, and the insulation film IF3.

First, using a photolithography method and an etching method, the cap film CP2, the gate pattern GP2, and the insulation film IF3 are sequentially removed. As a result, an opening surrounded by the sidewall spacer SW on the diffusion region MD side, and the gate insulation film GF1 is formed. Incidentally, in the present embodiment, the insulation film IF3 under the gate pattern GP2 is also removed. However, the insulation film IF3 may be left.

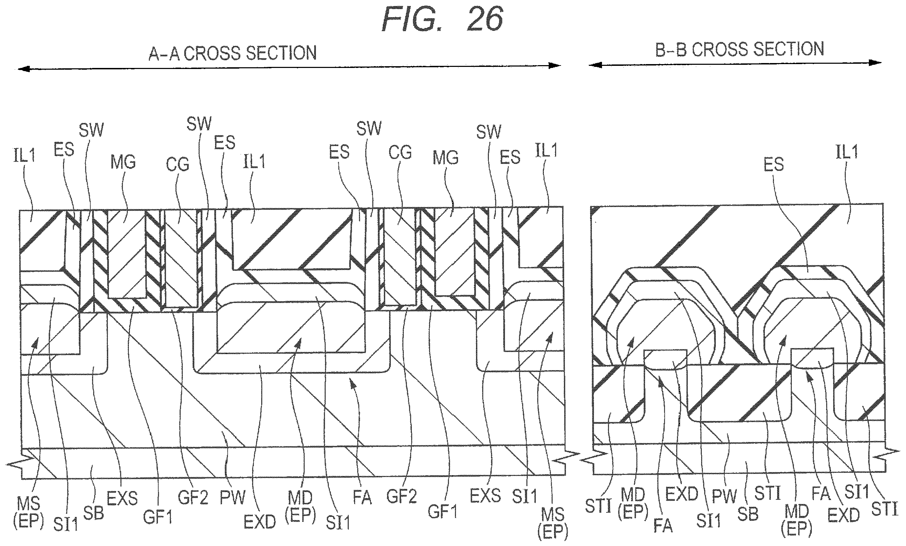

FIG. 26 shows the formation step of the gate insulation film GF2 and the control gate electrode CG.

First, in the opening of the region from which the gate pattern GP2 has been removed, a gate insulation film GF2 is formed using, for example, a CVD method or an ALD (Atomic layer Deposition) method. The gate insulation film GF2 is, for example, an oxide film including hafnium, an oxide film including zirconium, an oxide film including aluminum, an oxide film including tantalum, or, an oxide film including lanthanum, and has a film thickness of 1 to 2 nm. Specifically, the gate insulation film GF2 is a hafnium oxide film (HfO₂ film), a zirconium oxide film (ZrO₂ film), an aluminum oxide film (Al₂O₃ film), a tantalum oxide film (Ta₂O₅ film), or a lanthanum oxide film (La₂O₃ film). Further, before the formation of the gate insulation film GF2, a silicon oxide film having a film thickness of about 1 nm may be formed at the bottom of the opening as an insulation film for stabilizing the interface level.

Subsequently, using, for example, a sputtering method, a metal film to be the control gate electrode CG is formed over the gate insulation film GF2. The metal film is formed of, for example, a monolayer metal film formed of a tantalum nitride film, a titanium aluminum film, a titanium nitride film, a tungsten film, or an aluminum film, or a lamination film of the films appropriately stacked.

Thereafter, for example, by a CMP method, the metal film and the gate insulation film GF2 formed outside the opening are polished and removed. As a result, the control gate electrode CG is formed in such a manner as to be buried in the opening via the gate insulation film GF2. Accordingly, the gate insulation film GF2 is formed in such a manner as to surround the bottom surface and the side surface of the control gate electrode CG. Incidentally, the polishing treatment retreats the upper surface of the interlayer insulation film IL1, and the upper surface of the etching stopper film ES, and removes the cap film CP1 over the memory gate electrode MG.

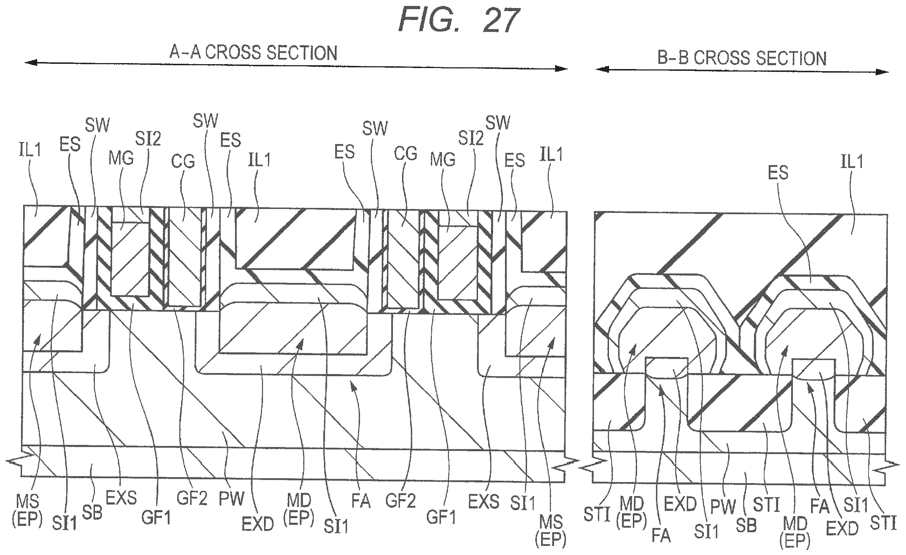

FIG. 27 shows the formation step of the silicide layer SI2.

By the same method as the formation step of the silicide layer SI1 described by reference to FIG. 23, a silicide layer SI2 is formed over the memory gate electrode MG. The silicide layer SI2 is formed of, for example, cobalt silicide (CoSi₂), nickel silicide (NiSi), or nickel platinum silicide (NiPtSi).

Following the manufacturing step of FIG. 27, an interlayer insulation film IL2, an interlayer insulation film IL3, plugs PG, and a wire M1 are formed, thereby to manufacture the semiconductor device of the present embodiment shown in FIG. 4.

First, over the interlayer insulation film IL1, over the control gate electrode CG, and over the memory gate electrode MG, the interlayer insulation film IL2 formed of, for example, a silicon oxide film is formed by, for example, a CVD method. Then, contact holes are formed in the interlayer insulation film IL2, the interlayer insulation film IL1, and the etching stopper film ES. In each of the contact holes, a conductive film mainly including tungsten (W), or the like is buried, thereby to form a plurality of plugs PG. At this step, by the same step, the pugs PG as shown in FIG. 2 are formed over the control gate electrode CG and over the memory gate electrode MG. As a result, the diffusion region MD and the diffusion region MS are electrically coupled with the plugs PG via the silicide layer SI1, the memory gate electrode MG is electrically coupled with the plug PG via the silicide layer SI2, and the control gate electrode CG is electrically coupled with the plug PG.

Then, over the interlayer insulation film IL2 including the plugs PG buried therein, an interlayer insulation film IL3 is formed. Thereafter, a wiring trench is formed in the interlayer insulation film IL3. Then, a conductive film including, for example, copper as the main component is buried in the wiring trench, thereby to form the wire M1 to be coupled to the plug PG in the interlayer insulation film IL3. The structure of the wire M1 is referred to as a so-called damascene wiring structure.

Thereafter, by a Dual Damascene method, or the like, second-or higher-layer wires are formed, but herein are not described and are not shown. Further, the wire M1 and higher-layer wires than the wire M1 are not limited to the damascene wiring structure, can also be formed by patterning a conductive film, and can be formed as, for example, a tungsten wire or an aluminum wire.

In the manner described up to this point, the semiconductor device of the present embodiment is manufactured.

### <Modified Example 1>

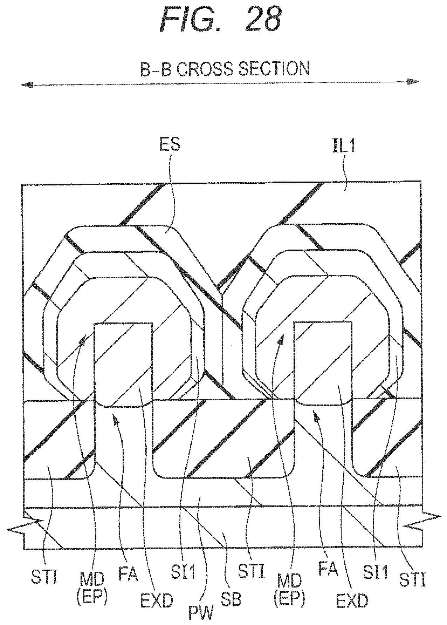

FIG. 28 shows Modified Example 1 of First Embodiment, and shows a cross sectional view corresponding to line B-B of FIG. 2.

In First Embodiment, before the formation step of the epitaxial layer EP, an etching treatment was performed, thereby to retreat the upper part of the fin FA.

In contrast, in Modified Example 1, with the fin FA not retreated, the epitaxial layer EP is formed at the fin FA. For this reason, the step of retreating the fin FA can be simplified, and hence the manufacturing cost can be reduced. Further, the silicon volume and surface area equivalent to those of First Embodiment can be obtained by epitaxial growth during a shorter time than in the case where the fin FA is retreated as in First Embodiment. For this reason, the manufacturing throughput can be improved.

Incidentally, in Modified Example 1, the fin FA is not retreated. As a result, as compared with First Embodiment, the height of the source region and the drain region increases. However, later steps include a step of polishing the memory gate electrode MG and the gate pattern GP2 by a CMP treatment, and replacing the gate pattern GP2 with the control gate electrode CG. When the height of the epitaxial layer EP is too high, the upper surface of the epitaxial layer EP is also exposed upon the polishing treatment. Accordingly, the epitaxial layer EP may also be removed upon removing the gate pattern GP2. Therefore, the upper surface of the epitaxial layer EP is desirably lower than respective final upper surfaces of the interlayer insulation film IL1, the memory gate electrode MG, and the control gate electrode CG.

### <Modified Example 2>

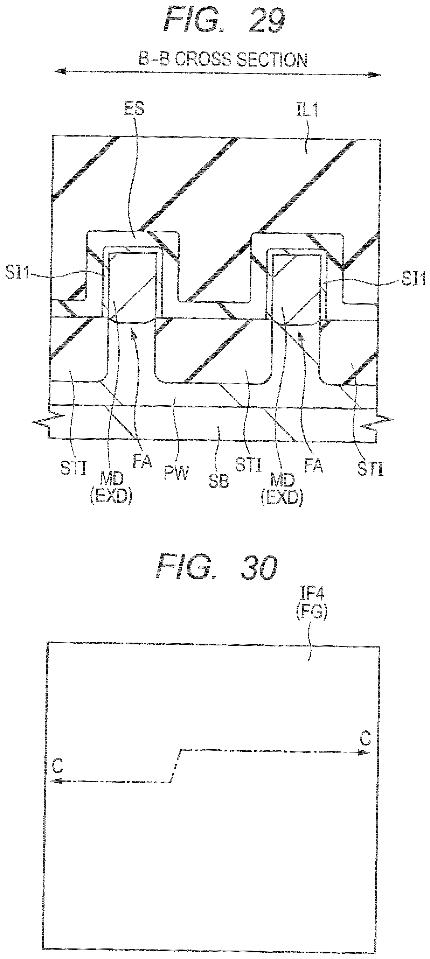

FIG. 29 shows Modified Example 2 of First Embodiment, and shows a cross sectional view corresponding to line B-B of FIG. 2.

In First Embodiment, the epitaxial layer EP was formed at the fin FA, and the silicide layer SI1 was formed over the epitaxial layer EP.

In contrast, in Modified Example 2, the epitaxial layer EP is not formed at the fin FA, and the fin FA is even not retreated. Further, the diffusion region MD is formed in the fin FA by an ion implantation method. In FIG. 29, the diffusion region MD is integrated with the extension region EXD. Furthermore, the silicide layer SI1 is formed directly over the upper surface and over the side surface of the fin FA.

In Modified Example 2, the epitaxial layer EP is not formed at the fin FA. As a result, each volume of the source region and the drain region is decreased as compared with First Embodiment, resulting in an increase in respective resistance values. However, when the width of the fin FA is sufficiently wide, and the characteristics required of the memory cell MC can be satisfied, the semiconductor device of Modified Example 2 is advantageous in being capable of reducing the manufacturing cost.

### <Description of power feeding part of memory cell MC>

Below, a description will be given to the features of the structure of the power feeding part of the memory cell MC of First Embodiment. Incidentally, the description on the power feeding part is also the same as in Modified Example 1 and Modified Example 2 of First Embodiment.

The power feeding part of the memory cell MC is the region of the plan view shown in FIG. 2 where respective ends of the memory gate electrode MG and the control gate electrode CG extending in the Y direction are formed, and the region where the plug PG for applying a voltage to the memory gate electrode MG and the control gate electrode CG is arranged. In the power feeding part, the fin FA is not formed, and the memory gate electrode MG and the control gate electrode CG are situated over the element isolation part STI.

Below, first, the manufacturing steps of forming the structure of the power feeding part will be described in comparison with the steps described by reference to FIGS. 4 to 27. Then, a description will be given to the main features of the structure of the power feeding part.

FIGS. 30 to 49 are each an enlarged view of the essential part for illustrating the structure of the power feeding part.

FIGS. 30, 32, 34, 36, 38, 40, 42, 44, 46, and 48 are each an essential part plan view showing a part of FIG. 2 on an enlarged scale. Incidentally, in the plan views, for ease of understanding of the drawings, the gate insulation film GF1 and the gate insulation film GF2 are hatched.

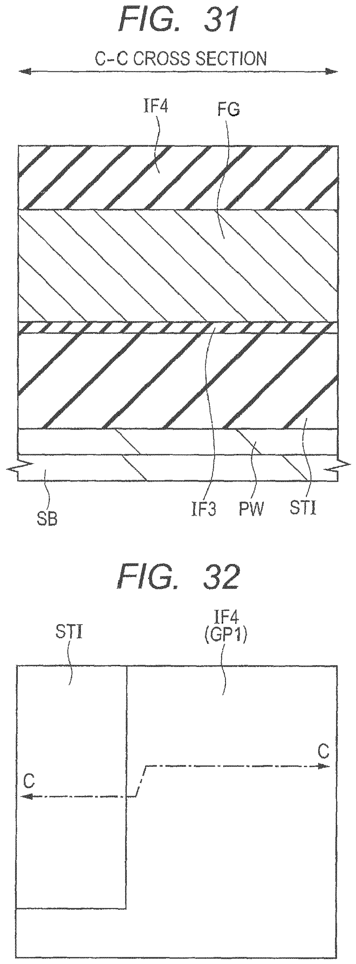

FIGS. 31, 33, 35, 37, 39, 41, 43, 45, 47, and 49 are each a cross sectional view along line C-C shown in each plan view.

FIGS. 30 and 31 correspond to the manufacturing step of FIG. 14. In the power feeding part, over the element isolation part STI, a conductive film FG is formed, and an insulation film IF4 is formed over the conductive film FG.

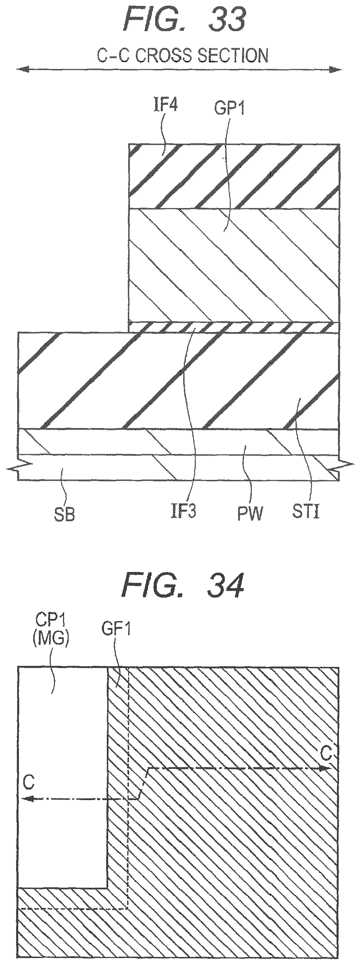

FIGS. 32 and 33 corresponds to the manufacturing step of FIG. 15. In the power feeding part, the conductive film FG is processed into the gate pattern GP1, and the region from which the conductive film FG has been removed becomes the region where the memory gate electrode MG is formed later.

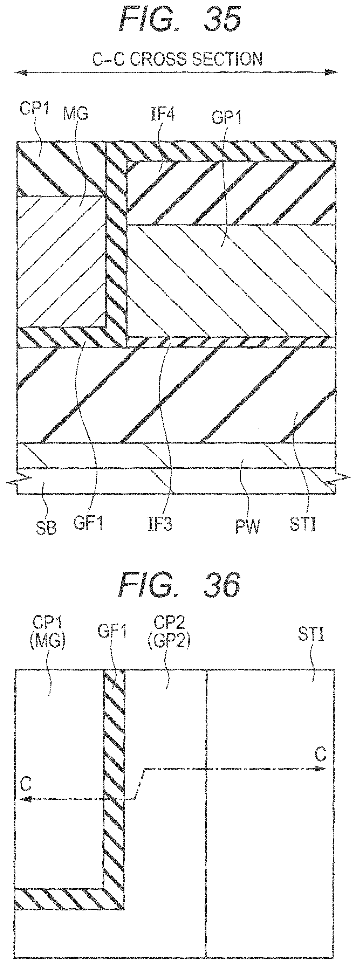

FIGS. 34 and 35 correspond to the manufacturing step of FIG. 17. In the region from which the conductive film FG was removed, the gate insulation film GF1 is formed. Over the gate insulation film GF1, the memory gate electrode MG and the cap film CP1 are formed in such a manner as to be buried. As a result, in a plan view, the gate insulation film GF1 is formed over the side surface of the memory gate electrode MG along the Y direction, and formed over the side surface of the memory gate electrode MG along the X direction. Further, the gate insulation film GF1 is also formed over the insulation film IF4.

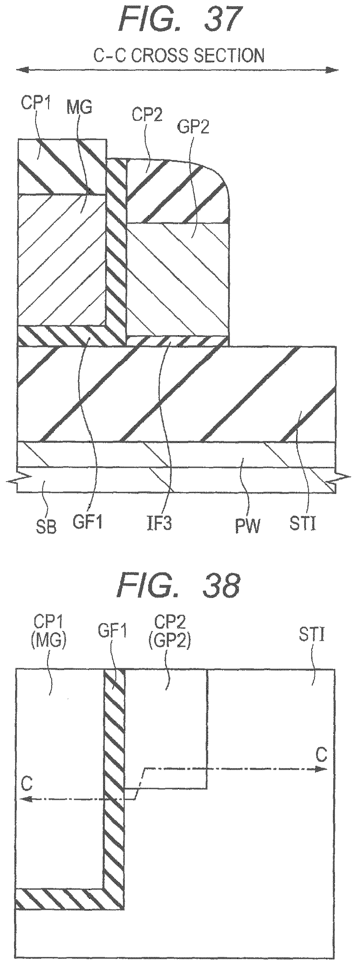

FIGS. 36 and 37 correspond to the manufacturing step of FIG. 19. The gate insulation film GF1 formed over the insulation film IF4 is removed. Subsequently, the insulation film IF4 is also removed. Thereafter, a cap film CP2 is formed over the gate pattern GP1. Using the cap film CP2 as a mask, an etching treatment is performed. As a result, the gate pattern GP1 is processed, and the gate pattern GP2 is formed. Further, the memory gate electrode MG and the gate pattern GP2 are insulated and separated from each other by the gate insulation film GF1.

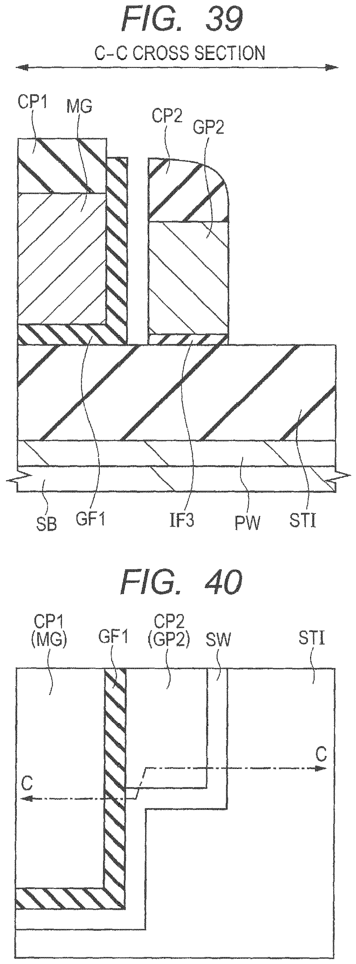

FIGS. 38 and 39 correspond to the manufacturing step of FIG. 20. The step of FIG. 20 is the step of removing the gate pattern GP2 formed at a site to be the source region. At this step, as shown in FIG. 38, at the power feeding part, a part of the gate pattern GP2 is removed so as to be in the shape of the control gate electrode CG later. That is, at the power feeding part, a part of the gate pattern GP2 is removed, thereby to determine the end of the gate pattern GP2 extending in the Y direction (the end of the control gate electrode CG). For this reason, as shown in FIG. 39, a gap is formed between the side surface of the gate pattern GP2 along the X direction and the side surface of the memory gate electrode MG along the Y direction via the gate insulation film GF1.

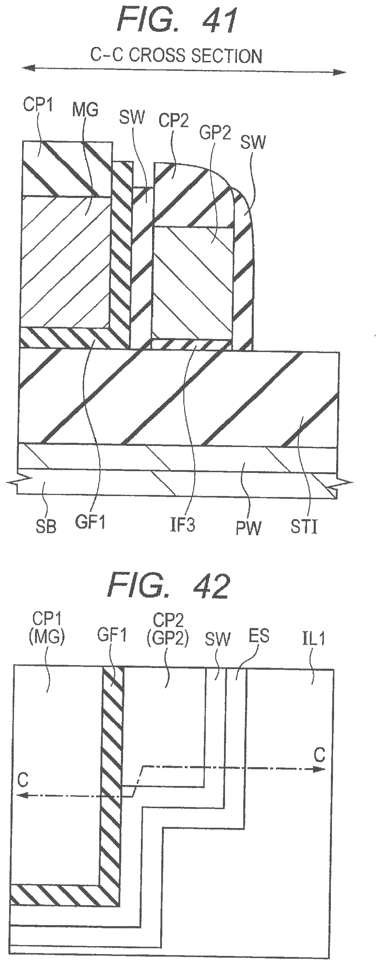

FIGS. 40 and 41 correspond to the manufacturing step of FIG. 23. This step forms the sidewall spacer SW over the side surface of the gate pattern GP2 along the Y direction, over the side surface of the gate pattern GP2 along the X direction, over the side surface of the memory gate electrode MG along the Y direction, and over the side surface of the memory gate electrode MG along the X direction in a plan view.

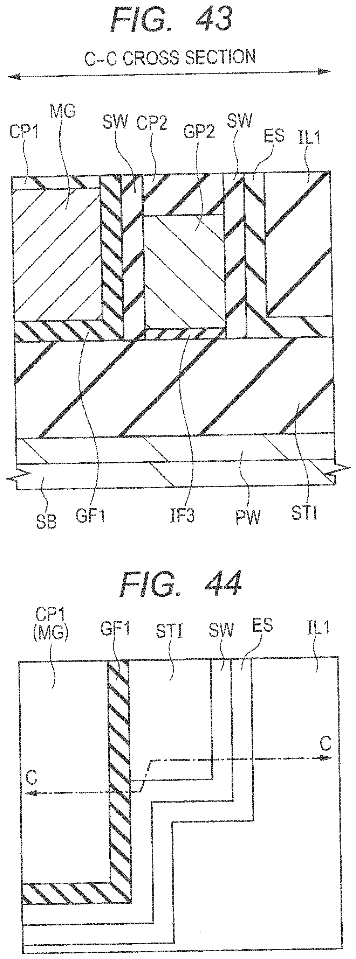

FIGS. 42 and 43 correspond to the manufacturing step of FIG. 24. The etching stopper film ES is formed in such a manner as to cover the memory gate electrode MG and the gate pattern GP2. Over the etching stopper film ES, the interlayer insulation film IL1 is formed. Thereafter, the interlayer insulation film IL1 and the etching stopper film ES are polished by a polishing treatment with a CMP method, so that the cap film CP1 and the cap film CP2 are exposed. Herein, the etching stopper film ES is left at the side surface of the sidewall spacer SW.

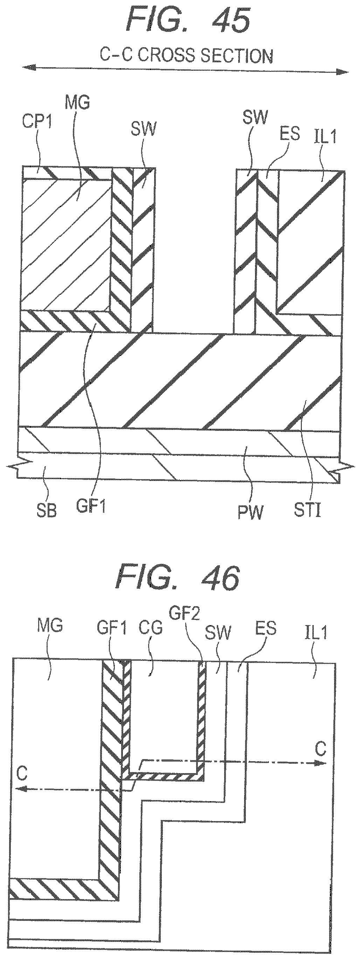

FIGS. 44 and 45 correspond to the manufacturing step of FIG. 25. The cap film CP2, the gate pattern GP2, and the insulation film IF3 are removed, thereby to open the region to be the control gate electrode CG.

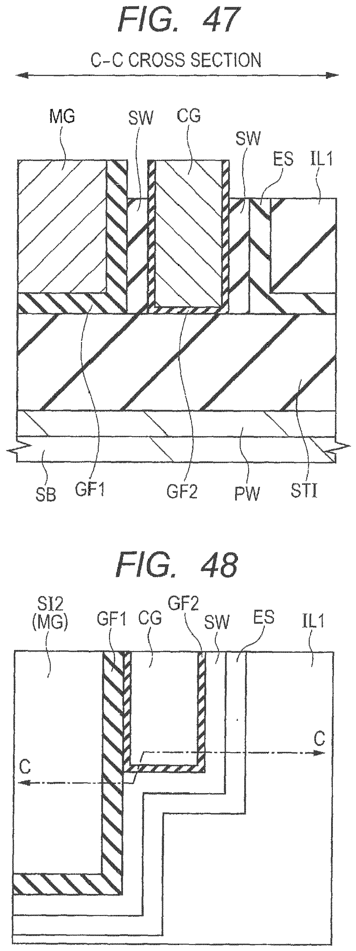

FIGS. 46 and 47 correspond to the manufacturing step of FIG. 26. A gate insulation film GF2 is formed in such a manner as to cover the region from which the gate pattern GP2 was removed, and the memory gate electrode MG. Over the gate insulation film GF2, a metal film for the control gate electrode CG is formed. Thereafter, the gate insulation film GF2 and the control gate electrode CG are buried and formed in the region from which the gate pattern GP2 was removed by a polishing treatment with a CMP method. This step forms the gate insulation film GF2 over the side surface of the control gate electrode CG along the Y direction, and over the side surface of the control gate electrode CG along the X direction in a plan view as shown in FIG. 46.

That is, as shown in FIG. 47, a description will be given along C-C cross section as follows: the gate insulation film GF1 is formed between the side surface of the memory gate electrode MG along the Y direction and the sidewall spacer SW, and the gate insulation film GF2 is formed between the side surface of the control gate electrode CG along the X direction, and the sidewall spacer SW.

Further, with the polishing treatment with a CMP method, there occurs a phenomenon in which the insulation film tends to be cut at the periphery of the end of the control gate electrode CG. In the region where the memory cell MC is formed, a plurality of control gate electrodes CG and memory gate electrodes MG are arranged at a given interval. Accordingly, even when a polishing treatment with a CMP method is performed between respective adjacent control gate electrodes CG and memory gate electrodes MG, the phenomenon in which an insulation film becomes more likely to be cut as with the periphery of the end of the control gate electrode CG at the power feeding part is less likely to occur. However, at the power feeding part, the arrangement of the control gate electrodes CG and the memory gate electrodes MG more often becomes more irregular, and the distance between respective electrodes is often longer as compared with the region of the memory cell MC.

Therefore, at the periphery of the end of the control gate electrode CG at the power feeding part, the height of each upper surface of the sidewall spacer SW, the etching stopper film ES, and the interlayer insulation film IL1 is lower than that of the periphery of the memory cell MC. That is, the position of the upper end of the sidewall spacer SW formed over the side surface of the control gate electrode CG along the X direction over the element isolation part STI of the power feeding part is lower than the position of the upper end of the sidewall spacer SW formed over the side surface of the control gate electrode CG along the Y direction at the fin FA at which the memory cell MC is formed. For this reason, at the power feeding part, a gap tends to be formed between the side surface of the memory gate electrode MG along the Y direction and the side surface of the control gate electrode CG along the X direction.

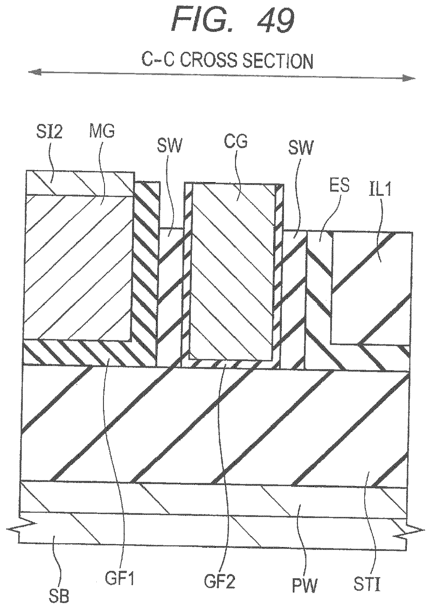

FIGS. 48 and 49 correspond to the manufacturing step of FIG.27. In this step, a silicide layer SI2 is formed over the memory gate electrode MG. Herein, entirely over the main surface of the semiconductor substrate SB, an insulation film for preventing the formation of the silicide layer is formed. Only the region where the silicide layer SI2 is formed is removed by wet etching. By the wet etching , the interlayer insulation film IL1 is also a little retreated.

As the main feature of the present embodiment, mention may be made of the following: in a plan view, the gate insulation film GF1 is formed over the side surfaces of the memory gate electrode MG along the X direction and the Y direction, and the gate insulation film GF2 is formed over the side surfaces of the control gate electrode CG along the X direction and the Y direction. That is, in a plan view, the entire side surface of the memory gate electrode MG is surrounded by the gate insulation film GF1, and the entire side surface of the control gate electrode CG is surrounded by the gate insulation film GF2.

For example, when the silicide layer SI2 is formed at the upper surface of the memory gate electrode MG as described above, the silicide layer SI2 may abnormally grow, resulting in a short circuit between the memory gate electrode MG and the control gate electrode CG. However, in the present embodiment, the gate insulation film GF1 and the gate insulation film GF2 are present between the memory gate electrode MG and the control gate electrode CG. For this reason, even when the silicide layer SI2 abnormally grows, the gate insulation film GF1 and the gate insulation film GF2 become the barrier, which can prevent the short circuit between respective gate electrodes.

Particularly, at the power feeding part, as described above, the insulation film (such as the sidewall spacer SW) is retreated, so that a gap tends to be formed between the memory gate electrode MG and the control gate electrode CG. This results in the situation in which the silicide layer SI2 tends to grow in such a manner as to fill the gap. Accordingly, a short circuit between respective gate electrodes tends to occur. However, in the present embodiment, at the power feeding part, the gate insulation film GF1 is formed over the side surface of the memory gate electrode MG along the Y direction, and the gate insulation film GF2 is formed over the side surface of the control gate electrode CG along the X direction. For this reason, even when the silicide layer SI2 abnormally grows, the short circuit between respective gate electrodes can be prevented. Therefore, it is possible to improve the reliability of the semiconductor device.

### <Comparison between semiconductor device of the present embodiment and semiconductor device of Study Example at power feeding part>

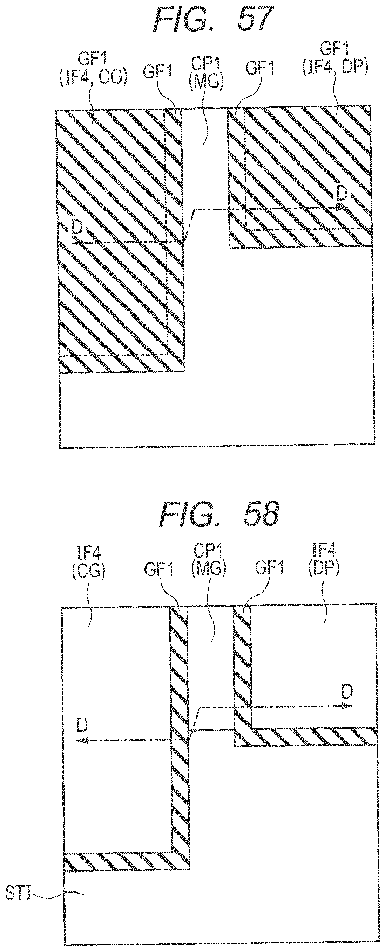

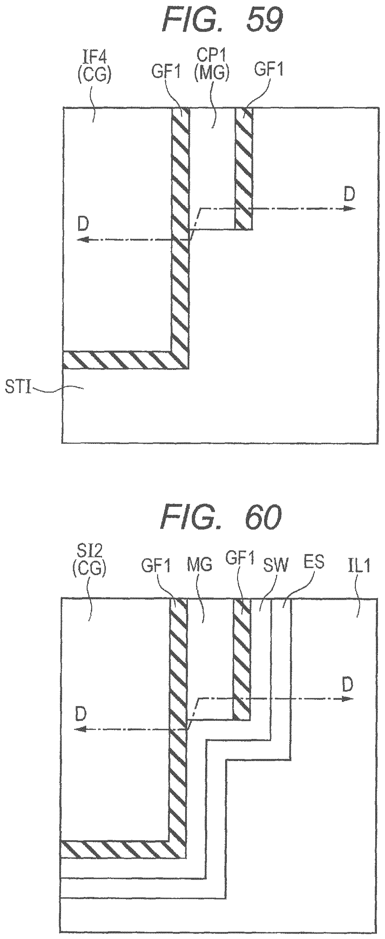

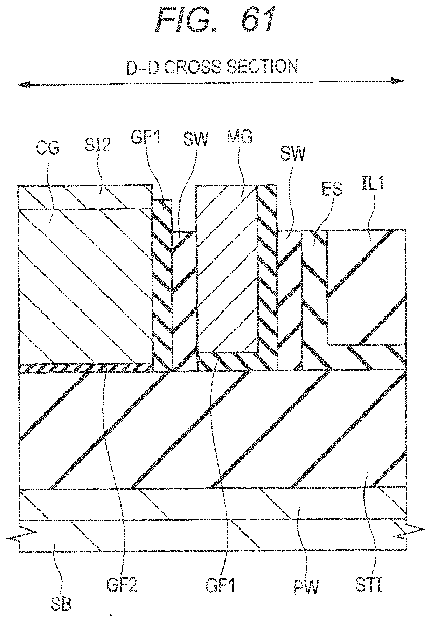

FIG. 57 to 61 each show the power feeding part of Study Example described by reference to FIGS. 51 to 56. FIGS. 57 to 60 are each a plan view of the power feeding part of Study Example, and FIG. 61 is a cross sectional view along line D-D shown in FIG. 60. Incidentally, FIGS. 57 to 60 are each a plan view in which for ease of understanding of the drawing, the gate insulation film GF1 is hatched.

FIG. 57 shows a plan view of the power feeding part at the step of FIG. 52 of Study Example. The gate insulation film GF1 is formed over the entire memory cell MC in such a manner as to cover the top of the upper surface and the top of the side surface of the patterned control gate electrode CG, and the top of the upper surface and the top of the side surface of the patterned dummy pattern DP. The memory gate electrode MG and the cap film CP1 are formed over the gate insulation film GF1. Incidentally, the memory gate electrode MG is retreated by the dry etching treatment as described by reference to FIG. 52. For this reason, as shown in FIG. 57, the memory gate electrode MG over the upper surface of the control gate electrode CG, and, over the upper surface of the dummy pattern DP is removed.

FIG. 58 shows a plan view of the power feeding part at the step of FIG. 53 of Study Example. In this step, the memory gate electrode MG and the gate insulation film GF1 formed at the side to be the drain region of the memory cell MC are removed. At this step, as shown in FIG. 58, at the power feeding part, the unnecessary portions of the memory gate electrode MG are removed, thereby to determine the end of the memory gate electrode MG extending in the Y direction. Herein, the gate insulation film GF1 is left not only over the side surface of the control gate electrode CG and over the side surface of the dummy pattern DP in the region where the memory gate electrode MG is left, but also over the entire side surface of the control gate electrode CG and over the entire side surface of the dummy pattern DP. This is due to the following: as described above, when the gate insulation film GF1 having a metal oxide film such as the charge accumulation layer CSL is removed using anisotropic etching, it is difficult to remove the gate insulation film GF1 over the side surface of the control gate electrode CG and over the entire side surface of the dummy pattern DP.

FIG. 59 shows a plan view of the power feeding part at the step of FIG. 54 of Study Example. In this step, the dummy pattern DP formed at the site to be the source region of the memory cell MC is removed. At this step, as shown in FIG. 59, the dummy pattern DP is also entirely removed at the power feeding part.

At this step, the gate insulation film GF1 left over the side surface of the dummy pattern DP along the X direction in FIG. 58 is left as an isolated pattern. However, as distinct from the gate insulation film GF1 left over the side surface of the memory gate electrode MG, and over the side surface of the control gate electrode CG, the isolated pattern is inferior in stability, and tends to fall. For this reason, the isolated pattern is peeled by the cleaning step after removal of the dummy pattern DP, and the like. FIG. 59 shows the state in which the gate insulation film GF1 left as the isolated pattern has been peeled.

Incidentally, when such an isolated pattern cannot be fully peeled, and is left, the isolated pattern may be unintentionally peeled during later manufacturing steps. For this reason, the isolated pattern may become a foreign matter over the semiconductor substrate and in the manufacturing device, which may result in a lower yield.

FIG. 60 shows the following state: from the state of FIG. 59, almost the same steps as the manufacturing steps of the present embodiment are performed, thereby to form the sidewall spacers SW, the etching stopper film ES, and the interlayer insulation film IL1; a polishing treatment with a CMP method is performed; then, the silicide layer SI2 is formed at the upper surface of the control gate electrode CG. FIG. 61 is a cross sectional view along line D-D shown in FIG. 60.

As indicated from FIGS. 60 and 61, in Study Example, the gate insulation film GF1 is left over the side surface of the control gate electrode CG, but the gate insulation film GF2 is not formed. Further, in a plan view, the gate insulation film GF1 is not formed at the end of the memory gate electrode MG extending in the Y direction. That is, the gate insulation film GF1 is not formed over the side surface of the memory gate electrode MG along the X direction. Further, as with the present embodiment, the sidewall spacers SW, the etching stopper film ES, and the interlayer insulation film IL1 are retreated at the power feeding part by a CMP polishing treatment.

In the present embodiment, as described above, the gate insulation film GF1 is formed over the side surface of the memory gate electrode MG, and the gate insulation film GF2 is formed over the side surface of the control gate electrode CG. Particularly, at the power feeding part, the gate insulation film GF1 is formed over the side surface of the memory gate electrode MG along the Y direction, and the gate insulation film GF2 is formed over the side surface of the control gate electrode CG along the X direction.

In Study Example, as compared with the present embodiment, the gate insulation film GF1 is not formed over the side surface of the memory gate electrode MG along the X direction. By this much, the insulation resistance between the memory gate electrode MG and the control gate electrode CG is lower at the power feeding part. That is, it is indicated as follows: when the silicide layer SI2 abnormally grows at the silicide layer SI2 formation step, the end of the memory gate electrode MG and the control gate electrode CG may highly possibly be short-circuited.

Further, in Study Example, as described by reference to FIG. 59, the gate insulation film GF1 may be left as the isolated pattern during the manufacturing step. In contrast, in the present embodiment, as described by reference to FIGS. 30 to 49, the gate insulation film GF1 is formed over the side surface of the memory gate electrode MG, and the gate insulation film GF2 is formed over the side surface of the control gate electrode CG. For this reason, the gate insulation film GF1 and the gate insulation film GF2 are not left as isolated patterns as in Study Example. Therefore, in the present embodiment, there is no fear that the isolated pattern becomes a foreign matter, resulting in a lower yield as in Study Example.

As described up to this point, in Study Example, the reliability of the semiconductor device is reduced. In contrast, in the present embodiment, the reliability of the semiconductor device can be improved.

### Second Embodiment

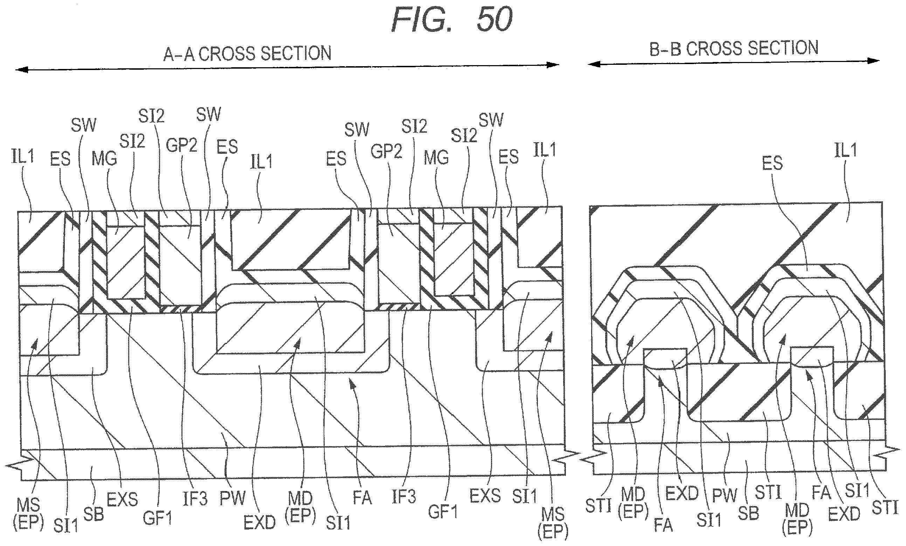

Below, a semiconductor device of Second Embodiment will be described by reference to FIG. 50.

In First Embodiment, the gate pattern GP2 and the insulation film IF3 were removed to form an opening. In the opening, a metal oxide film and a metal film were buried, thereby to form the gate insulation film GF2 and the control gate electrode CG.

In Second Embodiment, the gate pattern GP2 and the insulation film IF3 are not removed, and both are applied as a gate electrode and a gate insulation film, respectively. That is, in Second Embodiment, the control gate electrode is the gate pattern GP2 formed of, for example, a polycrystal silicon film, and the gate insulation film under the control gate electrode is the insulation film IF3 formed of, for example, a silicon oxide film.

One example of the manufacturing method for forming the structure of Second Embodiment will be described below.

First, the manufacturing steps of Second Embodiment are performed in the same manner as the manufacturing steps up to FIG. 24 of First Embodiment. Then, the polishing treatment with a CMP method for FIG. 24 is performed until the cap film CP1 over the memory gate electrode MG, and the cap film CP2 over the gate pattern GP2 are removed. As a result, the upper surface of the memory gate electrode MG, and the upper surface of the gate pattern GP2 are exposed.

Then, the same step as the formation step of the silicide layer SI2 described by reference to FIG. 27 of First Embodiment is carried out. As a result, as shown in FIG. 50, the silicide layers SI2 are formed over the memory gate electrode MG and over the gate pattern GP2, respectively.

The subsequent steps are the same as those of First Embodiment, and hence will not be described.

Up to this point, also in Second Embodiment, the gate insulation film GF1 including a metal oxide film is not formed over the upper surface and over the side surface of the fin FA to be the drain region. For this reason, with the semiconductor device of Second Embodiment, the formation of the extension region EXD, and the formation of the epitaxial layer EP are performed with stability as with First Embodiment.

Further, in Second Embodiment, as with First Embodiment, a metal oxide film is applied to the gate insulation film, and a metal film is not applied to the gate electrode. Therefore, First Embodiment is more advantageous than Second Embodiment in terms of miniaturization of the memory cell MC, an increase in speed, or the like.

However, Second Embodiment can simplify the manufacturing steps than First Embodiment, and hence can reduce the manufacturing cost.

Up to this point, the invention completed by the present inventors was specifically described by way of embodiments. However, the present invention is not limited to the embodiments, and may be variously changed within the scope not departing from the gist thereof.

## Claims

1. A method for manufacturing a semiconductor device, comprising the steps of:
(a) retreating a part of the upper surface of a semiconductor substrate, and forming a projecting part which is the part of the semiconductor substrate and which projects from the retreated upper surface of the semiconductor substrate and extends in a first direction along the main surface of the semiconductor substrate;
(b) forming a first conductive film in such a manner as to cover the upper surface and the side surface of the projecting part;
(c) patterning the first conductive film, and thereby forming a plurality of first gate patterns extending in a second direction orthogonal to the first direction;
(d) forming a first gate insulation film including a metal oxide film over the upper surfaces and the side surfaces of the first gate patterns, and over the upper surface and over the side surface of the projecting part between the mutually adjacent first gate patterns;
(e) forming a memory gate electrode extending in the second direction over the first gate insulation film in such a manner as to fill between the adjacent first gate patterns;
(f) after the step (e), removing the first gate insulation film formed over the upper surfaces of the first gate patterns;
(g) after the step (f), removing a part of the first gate patterns, and thereby forming a second gate pattern extending in the second direction, and formed of the remaining first gate pattern at the side surface of the memory gate electrode in the first direction via the first gate insulation film; and
(h) ion implanting the projecting part exposed from the memory gate electrode and the second gate pattern, and thereby forming an impurity region in the projecting part.

2. The method for manufacturing a semiconductor device according to claim 1,
wherein at the time of the step (h), the first gate insulation film is not formed at the upper surface and the side surface of the projecting part exposed from the memory gate electrode and the second gate pattern.

3. The method for manufacturing a semiconductor device according to claim 1 or 2, further comprising a step of:
(i) after the step (h), forming an epitaxial layer over the projecting part including the impurity region formed therein.

4. The method for manufacturing a semiconductor device according to claim 3, further comprising a step of:
(j) between the step (h) and the step (i), retreating the projecting part including the impurity region formed therein, wherein the epitaxial layer is formed over the retreated projecting part.

5. The method for manufacturing a semiconductor device according to claim 3 or 4, further comprising a step of:
(k) between the step (f) and the step (g), forming a cap film over the first gate patterns,
wherein the step (g) is performed using the cap film as a mask, and
wherein the step (i) is performed with the cap film left over the upper surface of the second gate pattern.

6. The method for manufacturing a semiconductor device according to claim 5, further comprising a step of:
(1) between the step (h) and the step (i), forming a sidewall spacer over the side surface of the second gate pattern,
wherein the position of the upper end of the sidewall spacer is lower than the upper surface of the cap film, and is higher than the boundary between the second gate pattern and the cap film.

7. The method for manufacturing a semiconductor device according to claim 6,
wherein the sidewall spacer is not formed over the side surface of the projecting part including the impurity region formed therein.

8. The method for manufacturing a semiconductor device according to one of claims 1 to 7, further comprising a step of:
(m) between the step (a) and the step (b), forming an element isolation part over the side surface of the projecting part, and over the semiconductor substrate,
wherein the position of the upper surface of the element isolation part is lower than the position of the upper surface of the projecting part, and
wherein the impurity region is formed at the entire projecting part situated above the upper surface of the element isolation part.

9. The method for manufacturing a semiconductor device according to one of claims 1 to 8, further comprising a step of:
(n) after the step (h), forming a silicide layer directly at the upper surface and the side surface of the projecting part including the impurity region formed therein.

10. The method for manufacturing a semiconductor device according to claim 1, further comprising a step of:
(o) after the step (h), forming a silicide layer at each upper surface of the memory gate electrode and the second gate pattern.

11. The method for manufacturing a semiconductor device according to one of claims 1 to 10, further comprising the steps of:
(p) after the step (h), forming an interlayer insulation film in such a manner as to cover the memory gate electrode, the second gate pattern, and the projecting part including the impurity region formed therein;
(q) polishing the interlayer insulation film by a CMP method;
(r) after the step (q), removing the second gate pattern;
(s) forming a second gate insulation film including a metal oxide film in a region from which the second gate pattern has been removed; and
(t) burying a control gate electrode including a metal film in the region from which the second gate pattern has been removed via the second gate insulation film.

12. The method for manufacturing a semiconductor device according to claim 11,
wherein in a plan view, the entire side surface of the memory gate electrode is surrounded by the first gate insulation film, and
wherein the entire side surface of the control gate electrode is surrounded by the second gate insulation film.

13. The method for manufacturing a semiconductor device according to one of claims 1 to 12,
wherein the first gate insulation film includes an insulation film having a trap level capable of holding electric charges, and
wherein the insulation film having the trap level is a hafnium silicate film, a hafnium oxide film, a zirconium oxide film, a zirconium oxynitride film, an aluminum nitride film, a hafnium oxynitride film, an aluminum oxide film, a hafnium / aluminate film, a yttrium oxide film, a terbium oxide film, a tantalum oxide film, a molybdenum oxide film, a praseodymium oxide film, a niobium oxide film, an erbium oxide film, a strontium titanate film, or, a barium titanate film.

14. A semiconductor device, comprising:
a memory gate electrode and a control gate electrode formed over a semiconductor substrate;
a first gate insulation film formed in such a manner as to surround the side surface and the bottom surface of the memory gate electrode; and
a second gate insulation film formed in such a manner as to surround the side surface and the bottom surface of the control gate electrode,
wherein in a plan view, the memory gate electrode and the control gate electrode are adjacent via the first gate insulation film and the second gate insulation film in a first direction, and extend in a second direction orthogonal to the first direction, respectively,
wherein in a plan view, the first gate insulation film is formed over the side surface of the memory gate electrode along the first direction and the second direction, and
wherein the second gate insulation film is formed over the side surface of the control gate electrode along the first direction and the second direction.

15. The semiconductor device according to claim 14, further comprising:
a plurality of projecting parts of a part of the semiconductor substrate, and extending in the first direction; and
an element isolation part formed over the semiconductor substrate between the projecting parts,
wherein the position of the upper surface of the element isolation part is lower than the position of each upper surface of the projecting parts,
wherein the memory gate electrode and the control gate electrode are formed over the element isolation part and over the projecting parts in such a manner as to cover the upper surfaces and the side surfaces of the projecting parts.

16. The semiconductor device according to claim 15,
wherein the side surface of the memory gate electrode along first direction, and the side surface of the control gate electrode along the first direction are situated over the element isolation part, respectively.

17. The semiconductor device according to claim 16, wherein the memory gate electrode includes a polycrystal silicon film, and a silicide layer formed over the polycrystal silicon film.

18. The semiconductor device according to claim 17,
wherein the control gate electrode includes a metal film, and/or
wherein the first gate insulation film includes an insulation film having a trap level capable of holding electric charges, and
wherein the insulation film having the trap level is a hafnium silicate film, a hafnium oxide film, a zirconium oxide film, a zirconium oxynitride film, an aluminum nitride film, a hafnium oxynitride film, an aluminum oxide film, a hafnium / aluminate film, a yttrium oxide film, a terbium oxide film, a tantalum oxide film, a molybdenum oxide film, a praseodymium oxide film, a niobium oxide film, an erbium oxide film, a strontium titanate film, or, a barium titanate film.

19. The semiconductor device according to claim 17,
wherein a sidewall spacer is formed over the side surface of the control gate electrode along the first direction and the second direction via the second gate insulation film, and
wherein the position of the upper end of the sidewall spacer formed over the side surface of the control gate electrode along the first direction over the element isolation part is lower than the position of the upper end of the sidewall spacer formed over the side surface of the control gate electrode along the second direction over the projecting parts.
